# EUROPEAN PATENT SPECIFICATION

(11) **EP 0 435 125 B1**
(45) Date of publication and mention of the grant of the patent: **24.05.1995**
(21) Application number: 90124436.8
(22) Date of filing: 17.12.1990
(51) Int. Cl.: H01S 3/13, H04B 10/00

(54) **Method and apparatus for stabilizing oscillation frequency separation among a plurality of laser devices**
Verfahren und Vorrichtung zur Stabilisierung des Frequenzabstands zwischen einer Anzahl von Lasern
Méthode et dispositif pour la stabilisation de la séparation de fréquence d'oscillation entre une pluralité de lasers

(30) Priority: 18.12.1989 JP 328823/89
(43) Date of publication of application: 03.07.1991
(73) Proprietor: NEC CORPORATION, Tokyo (JP)
(72) Inventor: Ono, Takashi, c/o NEC Corporation, Minato-ku, Tokyo (JP)
(74) Representative: VOSSIUS & PARTNER

(56) References cited:
- EP-A- 0 293 008
- EP-A- 0 351 816
- JP-A- 1 291 478
- PATENT ABSTRACTS OF JAPAN, vol. 13, no. 354 (E-802), 8th August 1989;& JP-A-01 114 090
- JOURNAL OF LIGHTWAVE TECHNOLOGY, vol. 5, no. 9, September 1987, pages 1301-1308, New York, US; K. NOSU et al.: "Optical FDM transmission technique"
- TECHNICAL DIGEST OF THE 5TH INTERNATIONAL CONFERENCE ON INTEGRATED OPTICS AND OPTICAL FIBER COMMUNICATION, vol. III, 1st - 4th October 1985, pages 61-64; E.-J. BACHUS et al.: "Coherent optical fiber subscriber line"

## Description

This invention relates to a method and an apparatus for stabilizing oscillation frequency separation among a plurality of laser devices, and more particularly to, a method and an apparatus for stabilizing oscillation frequency separation among a plurality of laser devices applied to optical communication in which light signals are transmitted in an optical frequency division multiplexing with a high density of frequencies to increase a transmission capacity.

A conventional method for stabilizing oscillation frequency separation among a plurality of laser devices has been described in EP-A-0 293 008.

In the method for stabilizing an oscillation frequency separation among a plurality of laser devices, a plurality of laser devices are controlled to emit output lights each having a predetermined frequency, so that a frequency separation is stabilized. Reference pulses are produced in an optical resonator which has periodic resonant frequencies and receives a frequency swept signal, and beat signals are produced in accordance with the combination of the frequency swept signal and oscillation frequencies of the plurality of laser devices. The reference signals and beat signals thus produced are processed to produce error signals which are time differences between the producing times of the both signals. The plurality of laser devices are controlled to be driven, such that the error signals become a predetermined value.

This known apparatus particularly comprises a sawtooth wave generator supplying an oscillation frequency sweep signal to a reference laser device. The light output of said reference laser device is divided by an optical divider into two light outputs, one light output is passed through an optical resonator and further to an optical detector which is connected to a control unit. The known apparatus further comprises a plurality of transmitting laser devices which outputs thereof are combined by means of an optical coupler. The output of this optical coupler is combined with the second output light of the optical divider by means of a second optical coupler. The output light of the second optical coupler is converted by an optical detector which is also connected to the control unit. The control unit produces control signals which are supplied to driver means for controlling the transmitting laser devices.

According to the conventional method for stabilizing oscillation frequency separation among a plurality of laser devices, however, there is a disadvantage in that the number of laser devices which are simultaneously controlled in the oscillation frequency separation is limited to approximately 10, because the number depends on a sweeping range of the frequency of the reference laser device.

Accordingly, it is an object of the invention to provide a method and an apparatus for stabilizing oscillation frequency separation among a plurality of laser devices in which the number of laser devices which are simultaneously controlled in the oscillation frequency separation is significantly increased not to be limited by a sweeping range of frequency of a reference laser device.

According to a first aspect of the invention, a method for stabilizing oscillation frequency separation among a plurality of laser devices, comprises:
sweeping oscillation frequencies of a plurality of reference laser devices in accordance with a corresponding signal of external signals supplied by a plurality of external signal generators to emit different frequency swept light outputs;
dividing each of the frequency swept light outputs emitted from each of the plurality of reference laser devices into first, second and third frequency swept light outputs, respectively;
combining the first frequency swept light outputs of the plurality of reference laser devices to produce a combined frequency swept light output;
passing the combined frequency swept light output through a first optical resonator having periodic resonant frequencies to produce a first reference light output at the periodic resonant frequencies, an interval between the periodic resonant frequencies of the first optical resonator being equal to a predetermined oscillation frequency separation among the plurality of reference laser devices;
converting the first reference light output into a first train of reference electric pulses;
dividing the first train of reference electric pulses into a plurality of first trains of reference electric pulses, a divided number being a number of the plurality of reference laser devices;
detecting each of the plurality of first trains of reference electric pulses synchronously to a corresponding external signal supplied from a corresponding signal generator of the plurality of external signal generators to produce synchronized electric signals;
filtering each of the synchronized electric signals to obtain a low frequency component of each of the synchronized electric signals as a reference error signal;
supplying each reference error signal to a corresponding laser device of the plurality of reference laser devices to control the oscillation frequencies of each of the plurality of reference laser devices such that an averaged center frequency of each of the plurality of reference laser devices is stabilized at one of transmission peaks of the first optical resonator;
driving a plural groups of laser devices each group including a plurality of transmitting laser devices to emit light outputs having oscillation frequencies in a frequency swept range of a light output from a corresponding reference laser device of the plurality of reference laser devices;
passing each of the second frequency swept light outputs emitted from the plurality of reference laser devices through a corresponding optical resonator of a plurality of second optical resonators each having periodic resonant frequencies to produce second reference light outputs at the periodic resonant frequencies, an interval between the periodic resonant frequencies of each of the second optical resonators being equal to a predetermined oscillation frequency separation among the plurality of transmitting laser devices in each group;
converting each of the second reference light outputs into a second train of reference electric pulses;
combining each of the third frequency swept light outputs and light outputs from the plurality of transmitting laser devices in each group to produce combined light signals;
converting the combined light signals into combined electric signals;
filtering the combined electric signals to produce a train of beat pulses corresponding to the oscillation frequencies of the plurality of laser devices;
comparing occurrence times of each of the train of beat pulses and those of the corresponding train of the second trains of reference electric pulses to produce an error signal corresponding to a time difference therebetween; and
controlling oscillation frequencies of the plurality of transmitting laser devices in each group such that the error signal is approximately equal to a predetermined value in respective group of the plurality of laser devices.

According to a second aspect of the invention, an apparatus for stabilizing oscillation frequency separation among a plurality of laser devices, comprises:
a plurality of oscillation frequency separation stabilizing units, each comprising a signal generator for generating an external signal of an oscillation frequency swept signal, a reference laser device to which the oscillation frequency swept signal is supplied, a plurality of transmitting laser devices each emitting a light output at an oscillation frequency range of a corresponding reference laser device of the plurality of reference laser devices, an optical divider for dividing a light output of the reference laser device into at least three light outputs, a first optical coupler for combining light outputs from the plurality of transmitting laser devices, a second optical coupler for combining one of the three light outputs and a light output combined in the first unit optical coupler, an optical resonator through which the other one of the three light outputs is passed to produce reference light outputs corresponding to resonant frequency peaks, first means for converting the reference light outputs to reference electric pulses, second means for converting a combined light output obtained in the second optical coupler to an electric signal, a low-pass filter through which a low frequency component of the electric signal is passed to produce beat pulses corresponding to the oscillation frequencies of the plurality of transmitting laser devices, means for producing error signals in accordance with a difference of occurrence times between the reference pulses and the beat pulses, and means for controlling the plurality of transmitting laser devices to be driven in accordance with the error signals, such that said error signals become a predetermined value;
an optical coupler for combining remaining light outputs of the at least three light outputs of the plurality of oscillation frequency separation stabilizing units to produce a combined frequency swept light output;
an optical resonator having periodic resonant frequencies through which the combined frequency swept light output is passed to produce a reference light output at the periodic resonant frequencies, an interval between the periodic resonant frequencies of the optical resonator being equal to a predetermined oscillation frequency separation among the plurality of reference laser devices;
means for converting the reference light output into a train of reference electric pulses;
a plurality of means for detecting a corresponding light signal of a plurality of first frequency swept light signals which are divided from the train of reference electric pulses synchronously to the external signal supplied from a corresponding signal generator of the plurality of external signal generators to produce a synchronized electric signal; and
a plurality of low-pass filters each passing a corresponding synchronized electric signal to obtain a low frequency component of each of the synchronized electric signals, a number of the low-pass filters being a number of the oscillation frequency separation stabilizing units.

### BRIEF DESCRIPTION OF THE DRAWINGS

The invention will be described in more detail in conjunction with appended drawings, wherein:
Fig. 1 is a block diagram showing an apparatus for stabilizing oscillation frequency separation among a plurality of laser devices in a first preferred embodiment according to the invention;
Fig. 2 is a schematic cross-sectional view illustrating a distributed Bragg reflector (DBR) type laser device used in the first preferred embodiment according to the invention;
Fig. 3 is a perspective view illustrating a distributed feedback (DFB) type laser device used in the first preferred embodiment according to the invention;
Fig. 4 is a block diagram showing a control unit in the first preferred embodiment according to the invention;
Fig. 5 is a circuit diagram showing a circuit for detecting the difference of pulse producing times in the first preferred embodiment according to the invention;
Fig. 6 is a circuit diagram showing a laser device driving means for driving the DFB type laser device in the first preferred embodiment according to the invention;
Fig. 7 is a diagram explaining relations among sweeping ranges of the frequencies of each of reference laser devices, the oscillation frequencies of the standard pulses and the beat pulses, and the pulse producing times in the first preferred embodiment according to the invention;
Figs. 8A to 8M are timing charts explaining operation in the first preferred embodiment according to the invention;
Figs. 9A to 9C are diagrams explaining relations between frequencies and detecting outputs of the lock-in amplifier in the first preferred embodiment according to the invention; and
Fig. 10 is a block diagram showing an apparatus for stabilizing oscillation frequency separation among a plurality of laser devices in a second preferred embodiment according to the invention.

### DESCRIPTION OF THE PREFERRED EMBODIMENTS

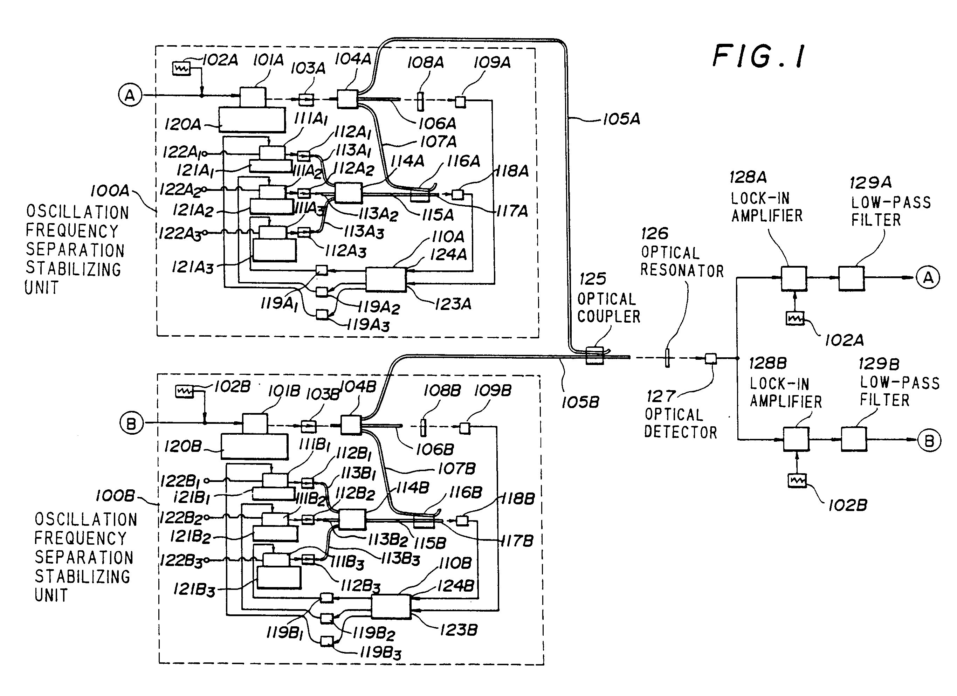

Fig. 1 shows an apparatus for stabilizing oscillation frequency separation among a plurality of laser devices in a first preferred embodiment according to the invention. The apparatus comprises two oscillation frequency separation stabilizing units 100A and 100B in each of which stabilization of oscillation frequency separation of a plurality of laser devices is carried out, an optical coupler 125, an optical resonator (a second etalon plate) 126, an optical detector 127, two lock-in amplifiers 128A and 128B, and two low-pass filters 129A and 129B.

The oscillation frequency separation stabilizing unit 100A comprises a distributed Bragg reflector type of a 1.55 » m band wavelength tunable distributed Bragg reflector (DBR) type semiconductor laser device 101A ( defined as "a DBR-LD" hereinafter), a sawtooth wave generator 102A from which a sawtooth wave current is injected into a phase control (PC) region and a DBR region of the DBR-LD 101A, an optical isolator 103A through which a light output of the DBR-LD 101A is passed, an optical divider 104A for dividing the light output from the DBR-LD 101A into three light outputs which are propagated through optical fibers 105A, 106A and 107A, a Fabry-Perot optical resonator (a first etalon plate) 108A having three resonant frequencies (equal to the number of below described laser devices 111A₁, 111A₂ and 111A₃ ) through which a light output supplied from the optical fiber 106A is passed to produce three light pulses in one period of the sawtooth wave of the sawtooth generator 102A based on the three resonant frequencies, an optical detector 109A for converting the three light pulses supplied from the optical resonator 108A to three electric pulses, the 1.55 » m band distributed feedback type laser devices 111A₁, 111A₂ and 111A₃ (defined as "DFB-LD" hereinafter) with modulation signal input terminals 121A₁, 121A₂ and 121A₃ among which oscillation frequency separation is stabilized and each of which is modulated in the frequency shift keying with a modulation rate of 400 Mb/s and a modulation index of 2.5, optical isolators 112A₁ , 112A₂ and 112A₃ through which light outputs of the DFB-LDs 111A₁ , 111A₂ and 111A₃ are passed, an optical coupler 114A for combining the light outputs propagated through the optical fibers 113A₁, 113A₂ and 113A₃, an optical coupler 116A for combining the light outputs propagated through the optical fibers 107A and 115A, an optical detector 118A for converting the light output thus combined in the optical coupler 116A and propagated through an optical fiber 117A to an electric signal, a control unit 124A for producing error signals in accordance with the electric signals received at input terminals 123A and 124A, laser device driving circuits 119A₁, 119A₂ and 119A₃ for driving the DFB-LDs 111A₁, 111A₂ and 111A₃ to stabilize the oscillation frequency separation, and temperature controlling means 120A, 122A₁, 122A₂ and 122A₃ on which the DBR-LD 101A, and the DFB-LDs 111A₁, 111A₂ and 111A₃ are mounted and in which the temperatures of these laser devices are stabilized within the temperature change of ± 0.1 °C, respectively.

The second oscillation frequency separation stabilizing unit 100B has the same structure as that of the first unit 100A, but each part is indicated by the same reference numeral having the letter "B" in place of "A".

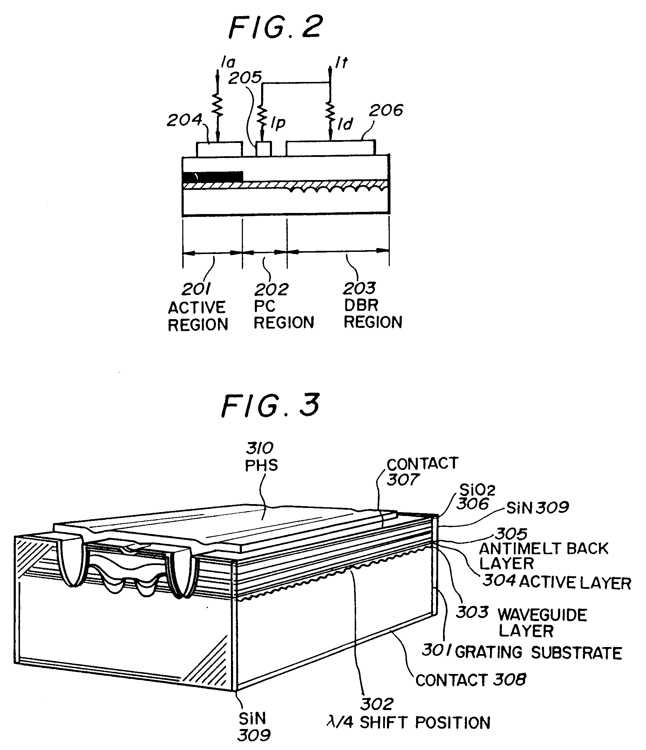

Fig. 2 shows the structure of the DBR-LD 101A. The structure of the DBR-LD has been described in detail on pages 403 to 405 of "Electronics letters, 9th April 1987, Vol, 23, No. 8". The DBR-LD comprises an active region 201, a PC (phase control) region 202, and a DBR (distributed Braggy reflector) region 203, into which currents Ia, Ip and Id are injected through respective electrodes 204, 205 and 206. The current Ia which is injected into the active region 201 is mainly a current for oscillating the DBR-LD, while the currents Ip and Id (divided dependent on respective resistance values from a total current It) are mainly currents for tuning an oscillation wavelength thereof.

The Fabry-Perot optical resonator 108A has been described in detail in Chapter 4 of "Optical electronics, 1985, authored by Ammon Yariv" published by Halt, Rinehart and Winston Inc. In the first preferred embodiment, an etalon plate made of quartz glass is used as the optical resonator, which has a refractive index of 1.5, a thickness of 1 cm, and a finesse is defined by a ratio of an optical resonant frequency separation in regard to a full width at half maximum of an optical pass-band in the center of an optical resonant frequency.

Fig. 3 shows the structure of the DFB-LD used in the first preferred embodiment. The structure of the DFB-LD has been described in detail in the report entitled "Highly stable single longitudinal mode operation in λ /4 shift 1.5 » m DFB-DC-PBH LDs" on pages 29 to 32 of "12th European Conference on Optical Communication, Technical Digest, Vol. 1, September 22/25, 1986". The DFB-LD comprises a first order InP grating substrate 301 including a λ /4 shift position 302, a waveguide layer 303, an active layer 304, an anti-meltback layer 305, and a SiO₂ film 306, and further comprises contacts 307 and 308 respectively provided on the top surface of layers sequentially grown on the grating substrate 301 and the back surface thereof, SiN films 309 provided on both side facets thereof, and a PHS layer 310 provided on the contact 307.

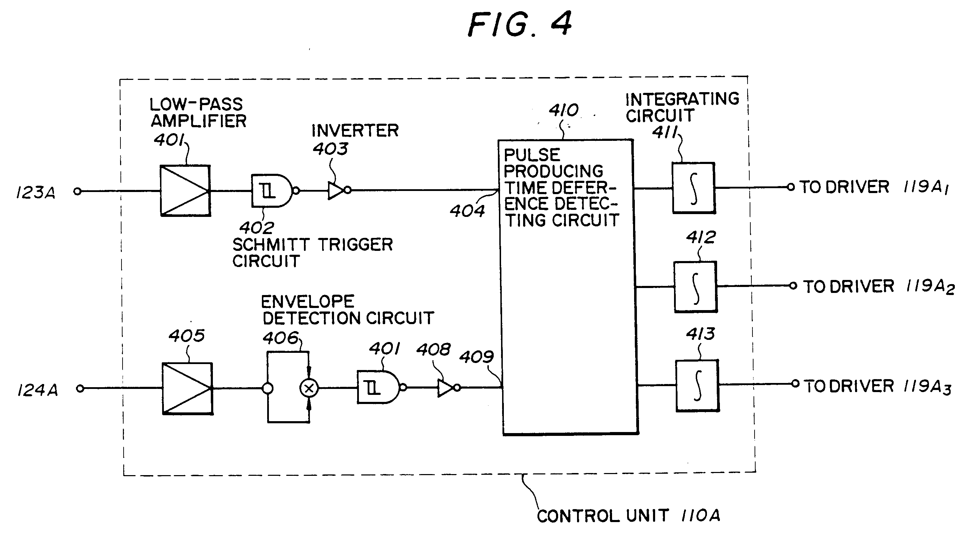

Fig. 4 shows a block diagram of the control unit 110A. The control unit 110A comprises a low-pass amplifier 401 for amplifying electric signals of pulses received through the terminal 123A from the first unit optical detector 109A, a Schmitt trigger circuit 402 for producing logic signals each having a predetermined logic level in accordance with the outputs of the low-pass amplifier 401, an inverter 403 for inverting the logic signals, a low-pass amplifier 405 with a cut-off frequency of 100 MHz and a function of a low-pass filter for producing electric signals which are called to be "beat pulses" when the frequency difference of the output lights between the DBR-LD 101A and the DFB-LDs 111A₁, 111A₂ and 111A₃ is in the range of approximately ± 100 MHz, an envelope detection circuit 406 in which the beat pulses are subject to an envelope detection, a Schmitt trigger circuit 402 for producing logic signals in accordance with the outputs of the envelope detection circuit 406, and an inverter 408 for inverting the logic signals, a pulse producing time difference detecting circuit 410 for detecting the difference of pulse producing times between the reference pulses and the beat pulses in accordance with the logic signals received at terminals 404 and 409 thereof, and integrating circuits 411, 412 and 413 for integrating a pulse producing time difference which is detected in the pulse producing time difference detecting circuit 410 to be supplied to the aforementioned drivers 119A₁, 119A₂ and 119A₃.

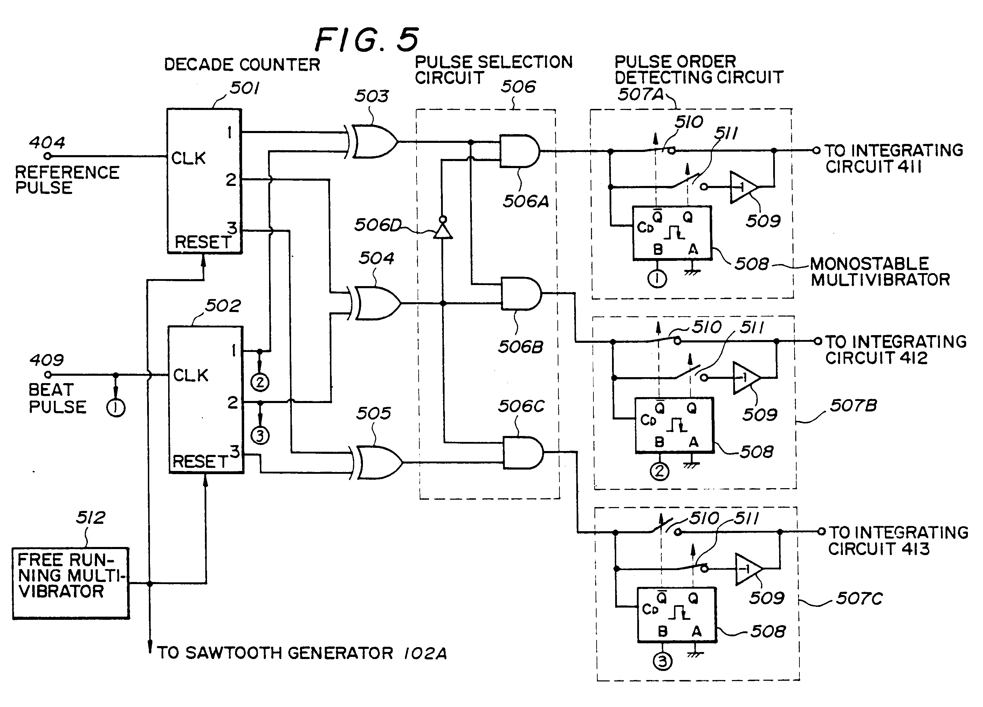

Fig. 5 shows the pulse producing time difference detecting circuit 410, which comprises a first decade counter 501 having a CLK input terminal for receiving the reference pulses at the terminal 404, and three output terminals 1 to 3 from which a series of square waves each becoming "high" by a reference pulse and "low" by a following reference pulse except for the output terminal 3 where a square wave becomes "high" by a reference pulse and "low" by the end of one period of a sawtooth wave received at a Reset terminal thereof are supplied sequentially, a second decade counter 502 which is the same function as the first decade counter 501 except that the beat pulses are received at the terminal 409, exclusive OR circuits 503 to 505 each connected through two input terminals to the corresponding output terminals 1, 2 or 3 of the first and second decade counters 501 and 502, a pulse selection circuit 506 including AND circuits 506A, 506B and 506C and an inverter 506D for selecting the passing of signals from the exclusive OR circuits 503 to 505 therethrough to the next stage, first to third pulse order detecting circuits 507A, 507B and 507C each detecting a pulse producing order between the reference pulse and the beat pulse, and a free running multi-vibrator 512 connected to the Reset terminals of the first and second decade counters 501 and 502 and to the sawtooth wave generator 102A. Each of the first to third pulse order detecting circuits 507A, 507B and 507C includes a monostable multi-vibrator 508, a polarity reversing circuit 509, and switches 510 and 511 which are turned on and off by outputs of terminals Q̅ and Q of the monostable multi-vibrator 508. In the pulse order detecting circuit 507A, the multi-vibrator 508 is connected at terminal C_{D} to the pulse selection circuit 506 and at terminal B to the output terminals 1 and 2 of the second decade counter 502, respectively.

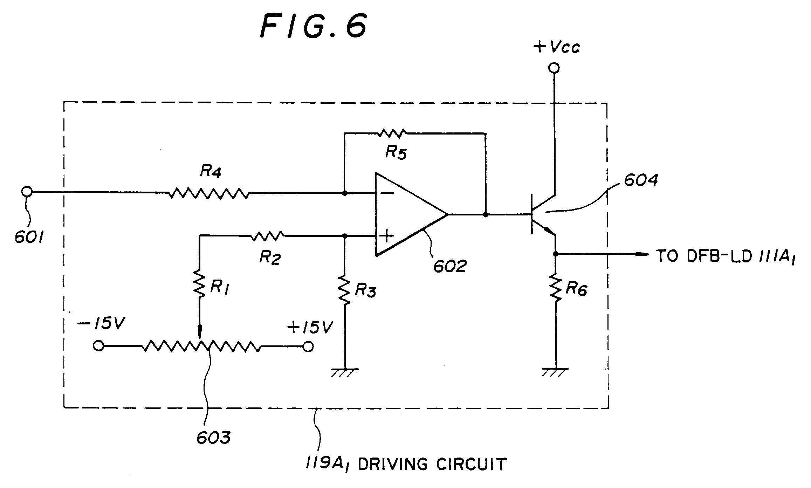

Fig. 6 shows the laser device driving circuit 119A₁ for driving the DFB-LD 111A₁ in accordance with the output of the integrating circuit 411 received at a terminal 601. The laser device driving circuit 119A₁ comprises an operational amplifier 602 having a positive terminal connected through resistances R₁ and R₂ to a reference voltage means 603 and through a resistance R₃ to the ground and a negative terminal connected through a resistance R₄ to the terminal 601 and to a feedback resistance R₅ , and a driving transistor 604 with a base connected to the operational amplifier 602, a collector connected to a power source +Vcc, and an emitter connected to the DFB-LD 111A₁ and through a resistance R₆ to ground.

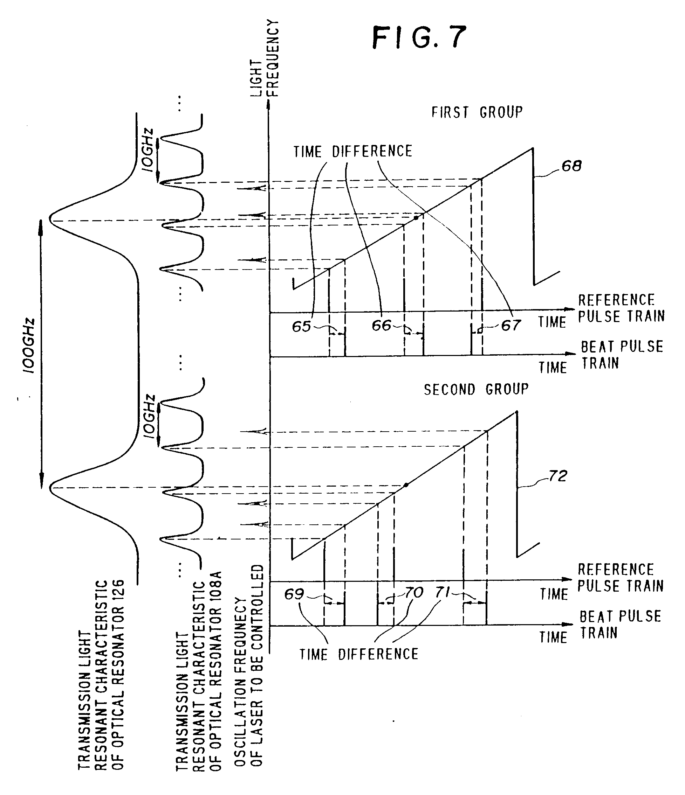

In operation, Fig. 7 shows relations among sweeping ranges of the frequencies of each reference laser device. In the first oscillation frequency separation stabilizing unit 100A, the frequency of the output light of the DBR-LD 101A changes relatively to times in accordance with a signal 68 which is a sawtooth wave having a repetition frequency of 2 KHz supplied from the sawtooth wave generator 102A. A light emitted from the DBR-LD 101A passes through the optical isolator 103A, and is then divided into three light outputs, namely first, second and third light outputs, to provide 1 : 1 : 1 power ratio division by the optical divider 104A. The first light output which is propagated through the optical fiber 106A passes through the optical resonator 108A, and is then supplied to the optical detector 109A. The optical detector 109A is supplied with light pulses at timings when the frequency of a light output of the DBR-LD 101A becomes equal to the resonance frequency of the optical resonator 108A. A peak voltage of an output of the sawtooth wave generator 102A is adjusted so that the optical detector 109A is supplied with three light pulses in each cycle of the sawtooth wave supplied from the sawtooth wave generator 102A. Then, an electric signal detected by the optical detector 109A is supplied to the input terminal 123A of the control unit 110A. On the other hand, light outputs emitted from the DFB-LDs 111A₁, 111A₂ and 111A₃ pass through the isolators 112A₁, 112A₂ and 112A₃, respectively, and are then combined together by the optical coupler 114A. The second light output from the optical divider 104A and the light output from the optical coupler 114A are then combined together by the optical coupler 116A. The combined light output of the optical coupler 116A is converted into an electric signal by the optical detector 118A. The electric signal is supplied to the input terminal 124A of the control unit 110A. On the other hand, the sawtooth wave generator 102B generates a sawtooth wave 72 having a repetition frequency of 2.1 KHz to be injected into the DBR-LD 101B. In addition, the resonant frequency separation of the optical resonator 126 which is 100 GHz is wider than that of the optical resonator 108A which is 10 GHz.

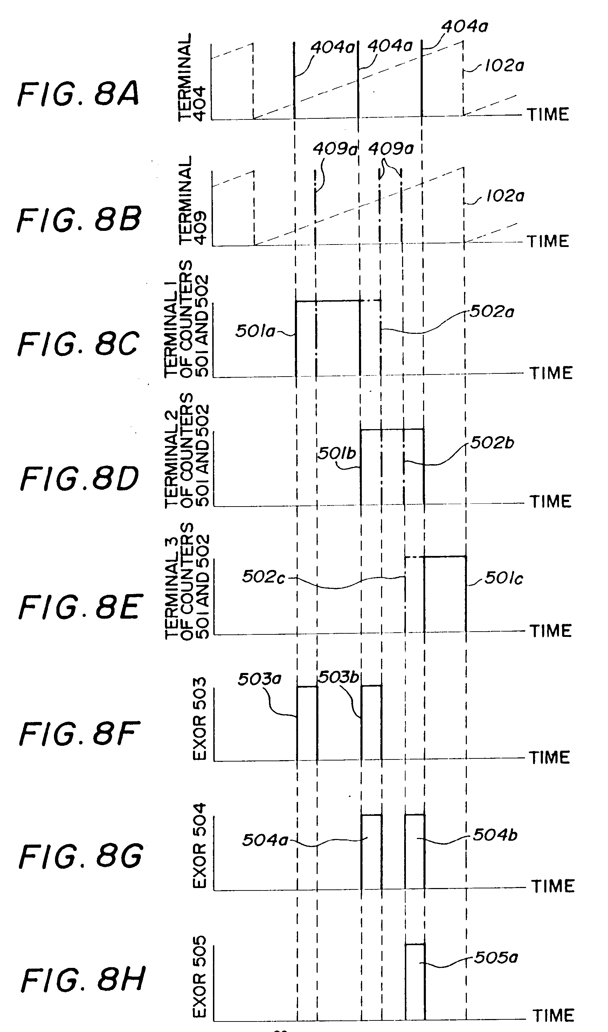

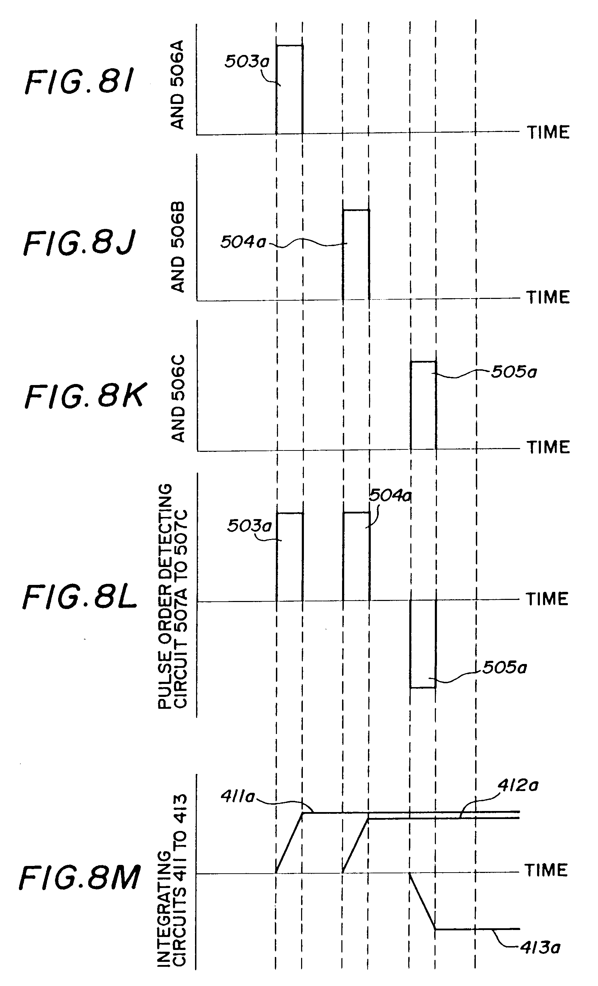

More precisely, the DBR-LD 101A is driven with current Ia injected into the active region 201 which includes a bias current of 50 mA and a sawtooth wave current 102a (as shown in Figs. 8A and 8B) having a repetition frequency of 2 KHz and a current range of 0 to 5.4 mA supplied from the sawtooth wave generator 102A, and with current It injected into the PC and DBR regions 202 and 203 which includes only a sawtooth wave current 102a having the same repetition frequency and current range as those for the active region 201 so that a sweep of an oscillation wavelength is performed in the DBR-LD 101A by a width of 45 GHz, and the injection of the sawtooth wave current 102a into the DBR-LD 101A compensates an absorption loss which is induced in the PC and DBR regions 202 and 203 by the injection of the sawtooth wave current 102a thereinto and refrains from the fluctuation of output light emitted from the DBR-LD 101A. The output light of the DBR-LD 101A is passed through the optical isolator 103A and then divided to be propagated through the optical fibers 105A, 106A and 107A by the optical divider 104A. The output light of the optical fiber 106A is supplied to the optical resonator 108A so that the three output lights of pulses are produced in one period of the sawtooth wave, when an oscillation frequency of the DBR-LD 101A coincides with the three resonant frequencies of the optical resonator 108A. Three output lights thus produced are converted in the optical detector 109A to the three electric signals which are then supplied to the terminals 123A of the control unit 110A. Simultaneously, the DFB-LDs 111A₁, 111A₂ and 111A₃ are driven to emit output lights which are passed through the optical isolators 112A₁, 112A₂ and 112A₃ by the laser device driving circuits 119A₁, 119A₂ and 119A₃ , respectively. The output lights which passed through the optical isolators 112A₁, 112A₂ and 112A₃ are propagated through the optical fibers 113A₁, 113A₂ and 113A₃, and then combined in the optical coupler 114A. The light output supplied from the optical coupler 114A is propagated through the optical fiber 115A and then combined in the optical coupler 116A with the light output of the optical fiber 107A. The combined light output from the optical coupler 116A is propagated through the optical fiber 117A, and then converted in the optical detector 118A into electric signals which are supplied to the input terminal 124A of the control unit 110A.

In the control unit 110A, the electric signals of pulses received at the input terminal 123A from the optical detector 109A are amplified in the low-pass amplifier 401 and then converted in the Schmitt trigger circuit 402 to the logic signals. The polarity of the logic signals is inverted to be applied to the input terminal 404 of the pulse producing time difference detecting circuit 410. The inverted logic signals are called "the first to third reference pulses 404a" as shown in Fig. 8A. The electric signals received at the input terminal 124A from the optical detector 118A are supplied to the low-pass amplifier 405 in which the three electric signals of pulses are produced to be beat signals when the difference of frequencies between the output light of the DBR-LD 101A and the output lights of the DFB-LDs 111A₁, 111A₂ and 111A₃ is in the range of ± 100 MHz so that the three pulses are obtained therein. The three pulses are subject to an envelope detection in the envelope detection circuit 406 and then converted in the Schmitt trigger circuit 401 to the logic signals which are then inverted in the inverter 408. The inverted logic signals are applied to the input terminal 409 of the pulse producing time difference detecting circuit 410 and shown to be "the first to third beat signals 409a" in Fig. 8B.

In the circuit 410, the first to third reference pulses 404a are applied to the decade counter 501, and the first to third beat pulses 409a are applied to the decade counter 502. In the decade counter 501, the first square wave 501a is produced at the terminal 1 during the time interval between the first and second reference pulses 404a as shown in Fig. 8C, the second square wave 501b is produced at the terminal 2 during the time interval between the second and third reference pulses 404a as shown in Fig. 8D, and the third square wave 501C is produced at the terminal 3 during the time interval between the third reference pulse 404a and the start of the next sawtooth wave signal 102a as shown in Fig. 8E. In the same manner, the first to third square waves 502a, 502b and 502c are produced at the terminals 1, 2 and 3 in accordance with the first to third beat pulses 409a and the sawtooth wave signal 102a as shown in Figs. 8C, 8D and 8E. Outputs of the terminals 1 of the decade counters 501 and 502 are supplied to the exclusive OR circuit 503, and those of the terminals 2 and 3 of the decade counters 501 and 502 are supplied to the exclusive OR circuits 504 and 505 respectively. Outputs of those exclusive OR circuits 503, 504 and 505 produced in the following truth table are shown in Figs. 8F to 8H by reference numerals 503a, 503b, 504a, 504b and 505a supplied to the pulse selection circuit 506.

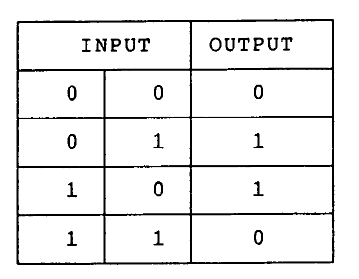

In the first AND circuit 506A, the pulse 503a is passed therethrough, while the pulse 503b is stopped to be passed therethrough as shown in Fig. 8I. That is, the earlier producing pulse 503a is only passed through the first AND circuit 506A in a case where the pulses 503a and 503b are supplied thereto. In the same manner, only the pulse 504a is passed through the second AND circuit 506B as shown in Fig. 8J, while the single pulse 505a is passed through the third AND circuit 506C as shown in Fig. 8K. The pulses 503a, 504a and 505a thus passed through the pulse selection circuit 506 are supplied to the first to third pulse order detecting circuits 507A, 507B and 507C. In the first pulse order detecting circuit 507A, the switch 510 is turned on, and the switch 511 is turned off for the reason that the terminals Q and Q̅ of the multi-vibrator 508 are "low" and "high" respectively, and a signal applied to the terminal B thereof is "low" when the pulse 503a is applied to the terminal C _{D} thereof so that the pulse 503a is supplied through the switch 510 to the integrating circuit 411 as shown in Fig. 8L. When the pulse 503a becomes "low", the first beat pulse 409 is applied to the terminal B of the the multi-vibrator 508.

In this case, the terminal C_{D} (corresponding to an enable terminal) is also "low", so that the terminals Q and Q̅ of the multi-vibrator 508 do not change even if the first beat pulse 409 is supplied to the terminal B. However, if the beat pulse 409a is generated earlier than the reference pulse 404a, the terminal C _{D} becomes "high" when the signal 503a becomes "high", and simultaneously the terminal B is supplied with the first beat pulse 409. In this case, the multi-vibrator 508 operates when the first beat pulse 409 is in declined state, so that the terminal Q becomes "high" from "low", and the terminal Q̅ becomes "low" from "high". As a result, the switch 511 becomes ON state, so that the inverting amplifier 509 starts operating, and the pulse order detecting circuit 507A produces a negative pulse.

This means that a pulse is passed through the pulse order detecting circuit 507A when the first reference signal 404a is produced earlier than the first beat signal 409a, while a pulse is inverted to be passed therethrough when the first reference signal 404a is produced later than the first beat signal 409a. In the second pulse order detecting circuit 507B, the pulse 504b is passed therethrough without being inverted, as shown in Fig. 8L, because the square wave signal 502a (as shown in Fig. 8C) becomes "low" when the pulse 504b becomes "low". In the third pulse order detecting circuit 507C, the pulse 505a is inverted to be passed therethrough as shown in Fig. 8L for the reason that the square wave signal 502b is applied to the terminal B of the multi-vibrator 508 before the pulse 505a is applied to the terminal C_{D} thereof so that the switch 510 is turned off, and the switch 510 is turned off when the square wave signal 502b becomes "low". The non-inverted pulses 503a and 504a and the inverted pulse 505a are integrated in the integrating circuits 411 to 413 during each two or three periods of the sawtooth waves 102a respectively to provide integrated values 411a, 412a and 413a as shown in Fig. 8M. Then integrated values 411a, 412a and 413a are applied to the laser device driving circuits 119A₁, 119A₂ and 119A₃, respectively. In the laser device driving circuits 119A₁, the integrated value 411a is applied to the terminal 601 thereof so that the operational amplifier 602 controls the driving transistor 604 to drive the DFB-LD 111A₁ in accordance with the difference between the integrated value 411a and the reference value obtained from the reference voltage means 603. As a result, the DFB-LD 111A₁ is driven by the driving current supplied from the driving transistor 604 which is added to a biased current. This means that the DFB-LDs 111A₁, 111A₂ and 111A₃ are controlled to emit light outputs having a predetermined frequency separation thereby minimizing the time difference between the aforementioned reference and beat pulses. As clearly understood from the above descriptions, a frequency separation is stabilized strictly in the same value as a free-spectrum range of the optical resonator among a plurality of laser devices in the oscillation frequency separation stabilizing unit 100A.

The same operation is carried out in the second oscillation frequency separation stabilizing unit 100B as in the first oscillation frequency separation stabilizing unit 100A as explained above.

Next, the third divided light outputs of the optical dividers 104A and 104B of the first and second oscillation frequency separation stabilizing units 100A and 100B are propagated through the optical fibers 105A and 105B to be combined in the optical coupler 125, and the combined light output from the optical coupler 125 is then supplied to the optical resonator 126 having a free spectrum range of 100 GHz. The light output passes through the optical resonator 126 and is converted into an electric signal by the optical detector 127. The electric signal is divided into first and second electric signals. The first divided electric signal is supplied to the lock-in amplifier 128A, in which the first electric signal is detected synchronously with a sawtooth wave signal 6B of the sawtooth wave generator 102A, as shown in Fig. 7. The output signal of the lock-in amplifier 128A is supplied to the low-pass filter 129A, through which a low frequency component of the signal is supplied to the DBR-LD 101A.

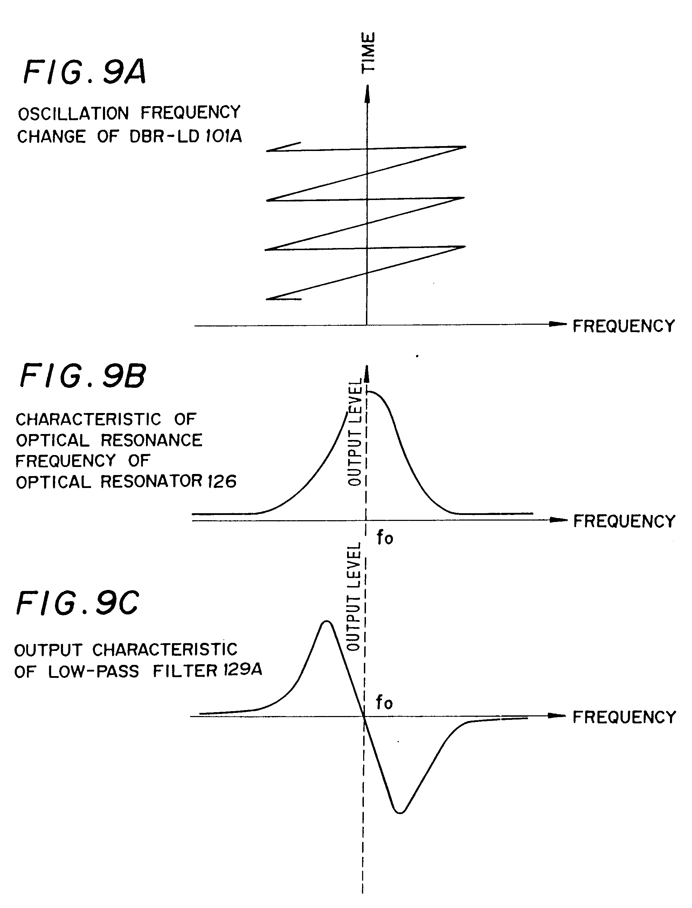

Figs. 9A to 9C explain detecting outputs of the lock-in amplifier 128A. The oscillation frequency of the DBR-LD 101A changes relatively to time due to the sweep of the sawtooth wave as shown in Fig. 9A, and the optical resonator 126 generates an output changing dependent on the change of the oscillation frequency of the DBR-LD 101A as shown in Fig. 9B. This low frequency component corresponds to a primary differentiated value of a transmission resonance characteristic of the optical resonator 126 as shown in Fig. 9C. That is, if an averaged oscillation center frequency of the DBR-LD 101A shifts on the lower frequency side relative to the peak resonance frequency f₀ of the optical resonator 126, the output of the low-pass filter 129A becomes a positive value. On the other hand, if an averaged oscillation center frequency of the DBR-LD 101A shifts on the higher frequency side relative to the peak resonance frequency f₀ of the optical resonator 126, the output of the low-pass filter 129A becomes a negative value. Accordingly, the averaged oscillation center frequency of the DBR-LD 101A is stabilized at the transmitting peak frequency of the optical resonator 126 by a feedback of the output of the low-pass filter 129A to the bias current of the sawtooth wave generator 102A which applies the sawtooth wave to the DBR-LD 101A so that the output of the low-pass filter 129A becomes zero. The same operation is carried out in the second oscillation frequency separation stabilizing unit 100B with the lock-in amplifier 128B and the low-pass filter 129B. As a result, the frequency separation of the two reference laser devices 101A and 101B are stabilized.

In such a manner as explained above, the oscillation frequencies of the three transmitting DFB-LDs of each unit are not only stabilized by the frequency separation which is equal to the free spectrum range of the optical resonator 108A or 108B, but a relative frequency separation is stabilized between the two units 100A and 100B.

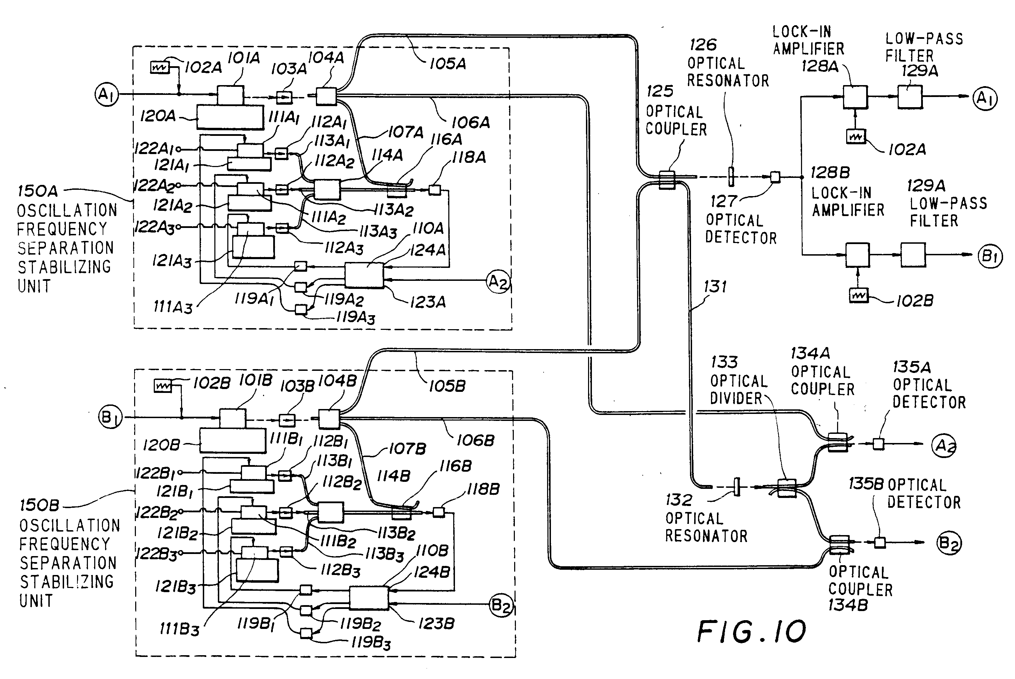

Fig. 10 shows an apparatus for stabilizing oscillation frequency separation among a plurality of laser devices in a second preferred embodiment according to the invention. The apparatus comprises two oscillation frequency separation stabilizing units 150A and 150B, optical couplers 125, 134A and 134B, optical resonators 126 and 132, optical detectors 127, 135A and 135B, an optical divider 133, lock-in amplifiers 128A and 128B, and low-pass filters 129A and 129B.

The structure of the oscillation frequency separation stabilizing units 150A and 150B is the same as that of the oscillation frequency separation stabilizing units 100A and 100B in Fig. 1, except that an optical resonator and an optical detector corresponding to the optical resonator 108A or 108B and the optical detector 109A or 109B are not, respectively, provided in the second preferred embodiment.

In operation, each one of divided light outputs of the optical dividers 104A and 104B are combined and then divided into first and second light outputs in the optical coupler 125. The first light output passes through the optical resonator 126 to produce a reference light output which is converted in the optical detector 127 into an electric signal to be used for stabilizing of frequency separation of the reference laser devices 101A and 101B. The electric signal is supplied to the lock-in amplifiers 128A and 128B, and the low-pass filters 129A and 129B to provide the same operation in the first preferred embodiment.

The second light output of the optical coupler 125 is propagated through the optical fiber 131, and then passes through the optical resonator 132. Then, the light output of the optical resonator 132 is divided into two light outputs to be supplied to the optical coupler 134A and 134B, respectively. In each of the optical couplers 134A and 134B, a corresponding light output from the optical divider 133 and a corresponding light output from the optical dividers 104A and 104B are combined, and the combined light signals are then converted into electric signals in the optical detectors 135A and 135B, respectively. The electric signals are supplied to the control units 110A and 110B, respectively. In this embodiment, the frequency separation of each group of the three laser devices is stabilized by the optical resonator 132, and a self-homodyne detection receiving is carried out in each of the optical detectors 135A and 135B.

In the first and second preferred embodiments, the DBR-LDs and the DFB-LDs are stabilized to be kept within ± 0.1°C of a predetermined temperature by the temperature controlling apparatus. The number of the DFB-LDs is not limited to "3", but may be changed, if the range of oscillation frequencies is within a swept frequency range. The number of the oscillation frequency separation stabilizing units may be also changed dependent on a resolution power of the lock-in amplifiers and a response speed of the control units. The frequency separation can be freely changed by changing a thickness of the etalon plate which is used for the optical resonator. A laser device to be controlled is not limited to a semiconductor laser device, but a laser device having an oscillation frequency which changes dependent on an applied external signal may be used. The lock-in amplifier may be replaced by an analog-operationable balance type mixer, a digital-operationable exclusive OR circuit, etc. having a detection function. The sawtooth wave which is used for the sweeping operation may be replaced by a triangle wave, a sine wave, etc.

Although the invention has been described with respect to specific embodiment for complete and clear disclosure, the appended claims are not limited to these embodiments.

## Claims

1. A method for stabilizing oscillation frequency separation among a plurality of laser devices, comprising:
sweeping oscillation frequencies of a plurality of reference laser devices (101A, 101B) in accordance with a corresponding signal of external signals supplied by a plurality of external signal generators (102A, 102B) to emit different frequency swept light outputs;
dividing (104) each of said frequency swept light outputs emitted from each of said plurality of reference laser devices into first, second and third frequency swept light outputs (105, 106, 107), respectively;
combining (125) said first frequency swept light outputs (105) of said plurality of reference laser devices to produce a combined frequency swept light output;
passing said combined frequency swept light output through a first optical resonator (126) having periodic resonant frequencies to produce a first reference light output at said periodic resonant frequencies, an interval between said periodic resonant frequencies of said first optical resonator being equal to a predetermined oscillation frequency separation among said plurality of reference laser devices;
converting (127) said first reference light output into a first train of reference electric pulses;
dividing said first train of reference electric pulses into a plurality of first trains of reference electric pulses, a divided number being a number of said plurality of reference laser devices;
detecting (128) each of said plurality of first trains of reference electric pulses synchronously to a corresponding external signal supplied from a corresponding signal generator of said plurality of external signal generators to produce synchronized electric signals;
filtering (129) each of said synchronized electric signals to obtain a low frequency component of each of said synchronized electric signals as a reference error signal;
supplying each reference error signal to a corresponding laser device of said plurality of reference laser devices to control the oscillation frequencies of each of said plurality of reference laser devices such that an averaged center frequency of each of said plurality of reference laser devices is stabilized at one of transmission peaks of said first optical resonator (126);
driving a plural groups of laser devices (111A₁-111A₃, 111B₁-111B₃) each group including a plurality of transmitting laser devices to emit light outputs having oscillation frequencies in a frequency swept range of a light output from a corresponding reference laser device of said plurality of reference laser devices;
passing each of said second frequency swept light outputs (106) emitted from said plurality of reference laser devices through a corresponding optical resonator of a plurality of second optical resonators (108A, 108B), each having periodic resonant frequencies to produce second reference light outputs at said periodic resonant frequencies, an interval between said periodic resonant frequencies of each of said second optical resonators being equal to a predetermined oscillation frequency separation among said plurality of transmitting laser devices in each group;
converting (109) each of said second reference light outputs into a second train of reference electric pulses;
combining (116) each of said third frequency swept light outputs (107) and light outputs from said plurality of transmitting laser devices in each group to produce combined light signals;
converting (118) said combined light signals into combined electric signals;
filtering (110, 405) said combined electric signals to produce a train of beat pulses corresponding to said oscillation frequencies of said plurality of laser devices;
comparing (110, 410)occurrence times of each of said train of beat pulses and those of the corresponding train of said second trains of reference electric pulses to produce an error signal corresponding to a time difference therebetween; and
controlling (119) oscillation frequencies of said plurality of transmitting laser devices in each group such that said error signal is approximately equal to a predetermined value in respective group of said plurality of laser devices.

2. A method for stabilizing oscillation frequency separation among a plurality of laser devices, comprising:
sweeping oscillation frequencies of a plurality of reference laser devices (101A, 101B) in accordance with a corresponding signal of external signals supplied by a plurality of external signal generators (102A, 102B) to emit different frequency swept light outputs;
dividing (104) each of said frequency swept light outputs emitted from each of said plurality of reference laser devices into first, second and third frequency swept light outputs (105, 106, 107), respectively;
combining (125) said first frequency swept light outputs (105) of said plurality of reference laser devices to produce a combined frequency swept light output;
dividing (125) said combined frequency swept light output into first and second combined frequency swept light outputs;
passing said first combined frequency swept light output through a first optical resonator (126) having periodic resonant frequencies to produce a first combined reference light output at said periodic resonant frequencies, an interval between said periodic resonant frequencies of said first optical resonator being equal to a predetermined oscillation frequency separation among said plurality of reference laser devices;
converting (127) said first combined reference light output into a first train of combined reference electric pulses;
dividing said first train of combined reference electric pulses into a plurality of first trains of reference electric pulses, a divided number being a number of said plurality of reference laser devices;
detecting (128) each of said plurality of first trains of reference electric pulses synchronously to a corresponding external signal supplied from a corresponding signal generator of said plurality of external signal generators to produce a synchronized electric signal;
filtering (129) each of said synchronized electric signals to obtain a low frequency component of each of said synchronized electric signals as a reference error signal;
supplying each reference error signal to a corresponding laser device of said plurality of reference laser devices to control oscillation frequencies of each of said plurality of reference laser devices such that an averaged center frequency of each of said plurality of reference laser devices is stabilized at one of transmission peaks of said first optical resonator;
passing said second combined frequency swept light output (131) through a second optical resonator (132) having periodic resonant frequencies to produce a second reference light output at said periodic resonant frequencies, an interval between said periodic resonant frequencies of said second optical resonator being equal to a predetermined oscillation frequency separation among said plurality of transmitting laser devices in each group;
dividing (133) said second reference light output into a plurality of second reference light outputs, a divided number being a number of said plurality of reference laser devices;
combining (134) each of said second frequency swept light outputs (106) and each one of said second reference light outputs to produce a third reference light output;
converting (135, 110, 402) each of said third reference light outputs into a second train of reference electric pulses;
driving plural groups of transmitting laser devices each group including a plurality of transmitting laser devices to emit light outputs having oscillation frequencies in a frequency swept range of a light output from a corresponding reference laser device of said plurality of reference laser devices;
combining (116) each of said third frequency swept light outputs (107) and light outputs from said plurality of transmitting laser devices in each group to produce combined light signals;
converting (118) each of said combined light signals into a combined electric signal;
filtering (110, 405) each of said combined electric signals to produce a train of beat pulses corresponding to said oscillation frequencies of a corresponding group of said plurality of transmitting laser devices;
comparing (110, 410) occurrence times of each of said train of beat pulses and those of a corresponding train of said second trains of reference electric pulses to produce an error signal corresponding to a time difference therebetween; and
controlling (119) oscillation frequencies of said plurality of transmitting laser devices in each group such that said error signal is approximately equal to a predetermined value in respective group of said plurality of laser devices.

3. An apparatus for stabilizing oscillation frequency separation among a plurality of laser devices, comprising:
a plurality of oscillation frequency separation stabilizing units (100A, 100B), each comprising a signal generator (102A, 102B) for generating an external signal of an oscillation frequency swept signal, a reference laser device (101A, 101B) to which said oscillation frequency swept signal is supplied, a plurality of transmitting laser devices (111A₁-111A₃, 111B₁-111B₃) each emitting a light output at an oscillation frequency range of a corresponding reference laser device of said plurality of reference laser devices, an optical divider (104A, 104B) for dividing a light output of said reference laser device into at least three light outputs (105A, 106A, 107A ; 105B, 106B, 107B), a first optical coupler (114A, 114B), for combining light outputs from said plurality of transmitting laser devices, a second optical coupler (116A, 116B) for combining one (107A, 107B) of said at least three light outputs and a light output combined in said first optical coupler, an optical resonator (108A, 108B) through which another one (106A, 106B) of said at least three light outputs is passed to produce reference light outputs corresponding to resonant frequency peaks, first means (109A, 109B) for converting said reference light outputs to reference electric pulses, second means (118A, 118B) for converting a combined light output obtained in said second optical coupler to an electric signal, a low-pass filter (110, 405) through which a low frequency component of said electric signal is passed to produce beat pulses corresponding to said oscillation frequencies of said plurality of transmitting laser devices, means (110, 410) for producing error signals in accordance with a difference of occurrence times between said reference pulses and said beat pulses, and means (119A₁-119A₃, 119B₁, 119B₃) for controlling said plurality of transmitting laser devices to be driven in accordance with said error signals, such that said error signals become a predetermined value;
an optical coupler (125) for combining remaining light outputs (105A, 105B) of said at least three light outputs of said plurality of oscillation frequency separation stabilizing units to produce a combined frequency swept light output;
an optical resonator (126) having periodic resonant frequencies through which said combined frequency swept light output is passed to produce a reference light output at said periodic resonant frequencies, an interval between said periodic resonant frequencies of said optical resonator being equal to a predetermined oscillation frequency separation among said plurality of reference laser devices;
means (127) for converting said reference light output into a train of reference electric pulses;
a plurality of means (128A, 128B) for detecting a corresponding light signal of a plurality of first frequency swept light signals which are divided from said train of reference electric pulses synchronously to said external signal supplied from a corresponding signal generator of said plurality of external signal generators to produce a synchronized electric signal; and
a plurality of low-pass filters (129A, 129B) each passing a corresponding synchronized electric signal to obtain a low frequency component of each of said synchronized electric signals, a number of said low-pass filters being a number of said oscillation frequency separation stabilizing units.

4. An apparatus for stabilizing oscillation frequency separation among a plurality of laser devices, comprising:
a plurality of oscillation frequency separation stabilizing units (150A, 150B), each of which comprising a signal generator (102A, 102B) for generating an external signal which is an oscillation frequency swept signal, a reference laser device (101A, 101B) to which said oscillation frequency swept signal is supplied over a range of frequencies from said signal generator, a plurality of laser devices (111A₁-111A₃, 111B₁-111B₃) emitting light outputs each at an oscillation frequency in the frequency range of said oscillation frequency sweep of light output from the corresponding reference laser device of said plurality of reference laser devices, an optical divider (104A, 104B) for dividing the light output of said reference laser device into at least three light outputs (105A, 106A, 107A ; 105B, 106B, 107B), a first optical coupler (114A, 114B) for combining light outputs from said plurality of laser devices, a second optical coupler (116A, 116B) for combining one (107A, 107B) of said at least three light outputs and the light outputs combined in said first optical coupler, means (118A, 118B) for converting the combined output light obtained in said second unit optical coupler to an electric signal, a low-pass filter (110, 405) through which a low frequency component of said electric signal is passed to produce beat pulses corresponding to said oscillation frequencies of said plural laser devices, means (110, 410) for producing error signals in accordance with the difference of the occurrence times between reference pulses and said beat pulses, and means (119A₁-119A₃, 119B₁-119B₃) for controlling said plural laser devices to be driven in accordance with said error signals, such that said error signals becomes a predetermined value;
a first optical coupler (125) which combines all of first frequency swept light outputs (105A, 105B) of said plurality of oscillation frequency separation stabilizing units to produce a combined frequency swept light output;
a first optical resonator (126) having periodic resonant frequencies through which said combined frequency swept light output is passed to produce a first combined reference light output at said periodic resonant frequencies, the interval between said periodic resonant frequencies of said first optical resonator being equal to a predetermined oscillation frequency separation among said plurality of reference laser devices;
means (127) for converting said first combined reference light output into a first train of combined electric reference pulses;
a plurality of means (128A, 128B) for detecting a corresponding light signal of a plurality of first frequency swept light signals which are divided from said first train of combined electric reference pulses synchronously to said external signal supplied from the corresponding signal generator of said plurality of external signal generators to produce a synchronized electric signal; and
a plurality of low-pass filters (129A, 129B) through each of which a corresponding synchronized electric signal is passed to obtain a low frequency component of each of said synchronized electric signal, whose number corresponds to that of said oscillation frequency separation stabilizing units;
a second optical resonator (132) having periodic resonant frequencies through which a divided light output (131) of said combined frequency swept light output is passed to produce a second combined reference light output at said periodic resonant frequencies, the interval between said periodic resonant frequencies of said second optical resonator being equal to a predetermined oscillation frequency separation among said plurality of laser devices;
an optical divider (133) which divides said second combined reference light output into a plurality of second reference light outputs whose number corresponds to that of said plurality of oscillation frequency separation stabilizing units;
a plurality of second optical couplers (134A,134B) each of which combines each of said second frequency swept light output (106) from each of said oscillation frequency separation stabilizing units and one of said plurality of second reference light outputs to produce a third reference light output;
a plurality of means (135A, 135B ; 110A, 110B, 402) for converting said third reference light output into said reference pulses.

5. An apparatus for stabilizing oscillation frequency separation among a plurality of laser devices, according to claim 3 or 4:
wherein said signal generator (102A, 102B) is a signal generator selected from a sawtooth wave generator, a triangle wave generator, and a sine curve wave generator.

6. An apparatus for stabilizing oscillation frequency separation among a plurality of laser devices, according to claim 3 or 4:
wherein said transmitting laser device (111A₁-111A₃, 111B₁-111B₃) is a semiconductor laser device.

7. An apparatus for stabilizing oscillation frequency separation among a plurality of laser devices, according to claim 3 or 4:
wherein said reference laser device (101A, 101B) is a DBR-LD.

8. An apparatus for stabilizing oscillation frequency separation among a plurality of laser devices, according to claim 3 or 4:
wherein said transmitting laser device (111A₁-111A₃, 111B₁-111B₃) is a DFB-LD.

9. An apparatus for stabilizing oscillation frequency separation among a plurality of laser devices, according to claim 3 or 4:
wherein said optical resonator (108A, 108B, 126; 132) is a Fabry-Perot optical resonator.

10. An apparatus for stabilizing oscillation frequency separation among a plurality of laser devices, according to claim 3 or 4:
wherein said detecting means (128A, 128B) is detecting means selected from a lock-in amplifier, a balancing type mixer operating in analogue, and an exclusive OR (EX-OR) circuit operating in digital.

## Patentansprüche

1. Verfahren zur Stabilisierung des Frequenzabstands zwischen einer Anzahl von Lasern, das aufweist:
Wobbeln der Frequenzen einer Anzahl von Referenzlasern (101A, 101B) entsprechend einem zugehörigen Signal aus externen Signalen, die von mehreren externen Signalgeneratoren (102A, 102B) geliefert werden, um verschiedene frequenzgewobbelte Lichtleistungen zu emittieren;
Teilen (104) jeder der frequenzgewobbelten von jedem der Anzahl von Referenzlasern emittierten Lichtleistungen jeweils in erste, zweite bzw. dritte frequenzgewobbelte Lichtleistungen (105, 106, 107);
Kombinieren (125) der ersten frequenzgewobbelten Lichtleistungen (105) der Anzahl von Referenzlasern, um eine kombinierte frequenzgewobbelte Lichtleistung zu erzeugen;
Durchlauf der kombinierten frequenzgewobbelten Lichtleistung durch einen ersten Lichtresonator (126) mit periodischen Resonanzfrequenzen, um eine erste Referenzlichtleistung bei den periodischen Resonanzfrequenzen zu erzeugen, wobei ein Intervall zwischen den periodischen Resonanzfrequenzen des ersten Lichtresonators gleich einem bestimmten Frequenzabstand zwischen der Anzahl von Referenzlasern ist;
Konvertieren (127) der ersten Referenzlichtleistung in eine erste Folge von elekrischen Referenzimpulsen;
Teilen der ersten Folge von elektrischen Referenzimpulsen in mehrere erste Folgen von elektrischen Referenzimpulsen, wobei die geteilte Zahl die Zahl der Anzahl von Referenzlasern ist;
Detektieren (128) jeder der Anzahl von ersten Folgen von elektrischen Referenzimpulsen synchron mit einem zugehörigen externen Signal, welches von einem zugehörigen Signalgenerator der Anzahl von externen Signalgeneratoren geliefert wird, um synchronisierte elektrische Signale zu erzeugen;
Filtern (129) jedes der synchronisierten elektrischen Signale, um von jedem der synchronisierten Signale eine Niederfrequenzkomponente als ein Referenzfehlersignal zu erhalten;
Liefern jedes Referenzfehlersignals an einen zugehörigen Laser der Anzahl von Referenzlasern, um die Frequenzen jedes der Anzahl von Referenzlasern derart zu steuern, daß eine gemittelte Mittenfrequenz jedes der Anzahl von Referenzlasern bei einer der Transmissionsspitzen des ersten Lichtresonators (126) stabilisiert wird;
An steuern mehrerer Gruppen von Lasern (111A₁-111A₃, 111B₁-111B₃), wobei jede Gruppe eine Anzahl von Sendelasern aufweist, um Lichtleistungen mit Frequenzen in einem frequenzgewobbelten Bereich einer Lichtleistung eines zugehörigen Referenzlasers der Anzahl von Referenzlasern zu emittieren;
Durchlauf jeder der zweiten frequenzgewobbelten von der Anzahl von Referenzlasern emittierten Lichtleistungen (106) durch einen zugehörigen Lichtresonator aus einer Anzahl zweiter Lichtresonatoren (108A, 108B) mit jeweils periodischen Resonanzfrequenzen, um zweite Referenzlichtleistungen bei den periodischen Resonanzfrequenzen zu erzeugen, wobei ein Intervall zwischen den periodischen Resonanzfrequenzen jedes der zweiten Lichtresonatoren gleich einem bestimmten Frequenzabstand zwischen der Anzahl von Sendelasern in jeder Gruppe ist;
Konvertieren (109) jeder der zweiten Referenzlichtleistungen in eine zweite Folge von elektrischen Referenzimpulsen;
Kombinieren (116) jeder der dritten frequenzgewobbelten Lichtleistungen (107) und der Lichtleistungen der Anzahl von Sendelasern in jeder Gruppe, um kombinierte Lichtsignale zu erzeugen;
Konvertieren (118) der kombinierten Lichtsignale in kombinierte elekrische Signale;
Filtern (110, 405) der kombinierten elektrischen Signale, um eine Folge von Schwebungsimpulsen zu erzeugen, die den Frequenzen der Anzahl von Lasern entsprechen;
Vergleichen (110, 410) von Auftrittszeiten jeder der Folgen von Schwebungsimpulsen und denjenigen der zugehörigen Folge der zweiten Folgen von elektrischen Referenzimpulsen, um ein einer dazwischenliegenden Zeitdifferenz entsprechendes Fehlersignal zu erzeugen; und
Steuern (119) von Frequenzen der Anzahl von Sendelasern in jeder Gruppe derart, daß das Fehlersignal ungefähr gleich einem bestimmten Wert in der jeweiligen Gruppe der Anzahl von Lasern ist.

2. Verfahren zur Stabilisierung des Frequenzabstands zwischen einer Anzahl von Lasern, das aufweist:
Wobbeln der Frequenzen einer Anzahl von Referenzlasern (101A, 101B) entsprechend einem zugehörigen Signal aus externen Signalen, die von mehreren externen Signalgeneratoren (102A, 102B) geliefert werden, um verschiedene frequenzgewobbelte Lichtleistungen zu emittieren;
Teilen (104) jeder der frequenzgewobbelten von jedem der Anzahl von Referenzlasern emittierten Lichtleistungen jeweils in erste, zweite bzw. dritte frequenzgewobbelte Lichtleistungen (105, 106, 107);
Kombinieren (125) der ersten frequenzgewobbelten Lichtleistungen (105) der Anzahl von Referenzlasern, um eine kombinierte frequenzgewobbelte Lichtleistung zu erzeugen;
Teilen (125) der kombinierten frequenzgewobbelten Lichtleistung in erste und zweite kombinierte frequenzgewobbelte Lichtleistungen;
Durchlauf der ersten kombinierten frequenzgewobbelten Lichtleistung durch einen ersten Lichtresonator (126) mit periodischen Resonanzfrequenzen, um eine erste kombinierte Referenzlichtleistung bei den periodischen Resonanzfrequenzen zu erzeugen, wobei ein Intervall zwischen den periodischen Resonanzfrequenzen des ersten Lichtresonators gleich einem bestimmten Frequenzabstand zwischen der Anzahl von Referenzlasern ist;
Konvertieren (127) der ersten kombinierten Referenzlichtleistung in eine erste Folge von kombinierten elektrischen Referenzimpulsen;
Teilen der ersten Folge von kombinierten elektrischen Referenzimpulsen in mehrere erste Folgen von elektrischen Referenzimpulsen, wobei die geteilte Zahl die Zahl der Anzahl von Referenzlasern ist;
Detektieren (128) jeder der Anzahl von ersten Folgen von elektrischen Referenzimpulsen synchron mit einem zugehörigen externen Signal, welches von einem zugehörigen Signalgenerator der Anzahl von externen Signalgeneratoren geliefert wird, um ein synchronisiertes elektrisches Signal zu erzeugen;
Filtern (129) jedes der synchronisierten elektrischen Signale, um von jedem der synchronisierten elektrischen Signale eine Niederfrequenzkomponente als ein Referenzfehlersignal zu erhalten;
Liefern jedes Referenzfehlersignals an einen zugehörigen Laser der Anzahl von Referenzlasern, um die Frequenzen jedes der Anzahl von Referenzlasern derart zu steuern, daß eine gemittelte Mittenfrequenz jedes der Anzahl von Referenzlasern bei einer der Transmissionsspitzen des ersten Lichtresonators stabilisiert wird;
Durchlauf der zweiten kombinierten frequenzgewobbelten Lichtleistung (131) durch einen zweiten Lichtresonator (132) mit periodischen Resonanzfrequenzen, um eine zweite Referenzlichtleistung bei den periodischen Resonanzfrequenzen zu erzeugen, wobei ein Intervall zwischen den periodischen Resonanzfrequenzen des zweiten Lichtresonators gleich einem bestimmten Frequenzabstand zwischen der Anzahl von Sendelasern in jeder Gruppe ist;
Teilen (133) der zweiten Referenzlichtleistung in eine Anzahl von zweiten Referenzlichtleistungen, wobei die geteilte Zahl die Zahl der Anzahl von Referenzlasern ist;
Kombinieren (134) jeder der zweiten frequenzgewobbelten Lichtleistungen (106) und jeder der zweiten Referenzlichtleistungen, um eine dritte Referenzlichtleistung zu erzeugen;
Konvertieren (135, 110, 402) jeder der dritten Referenzlichtleistungen in eine zweite Folge von elektrischen Referenzimpulsen;
Ansteuern mehrerer Gruppen von Sendelasern, wobei jede Gruppe eine Anzahl von Sendelasern aufweist, um Lichtleistungen mit Frequenzen in einem frequenzgewobbelten Bereich einer Lichtleistung eines zugehörigen Referenzlasers der Anzahl von Referenzlasern zu emittieren;
Kombinieren (116) jeder der dritten frequenzgewobbelten Lichtleistungen (107) und der Lichtleistungen der Anzahl von Sendelasern in jeder Gruppe, um kombinierte Lichtsignale zu erzeugen;
Konvertieren (118) jedes der kombinierten Lichtsignale in ein kombiniertes elektrisches Signal;
Filtern (110, 405) jedes der kombinierten elektrischen Signale, um eine Folge von Schwebungsimpulsen zu erzeugen, die den Frequenzen einer entsprechenden Gruppe der Anzahl von Sendelasern entsprechen;
Vergleichen (110, 410) der Auftrittszeiten jeder der Folgen von Schwebungsimpulsen und denjenigen einer zugehörigen Folge der zweiten Folgen von elektrischen Referenzimpulsen, um ein einer dazwischenliegenden Zeitdifferenz entsprechendes Fehlersignal zu erzeugen; und
Steuern (119) von Frequenzen der Anzahl von Sendelasern in jeder Gruppe derart, daß das Fehlersignal ungefähr gleich einem bestimmten Wert in der jeweiligen Gruppe der Anzahl von Lasern ist.

3. Vorrichtung zur Stabilisierung des Frequenzabstands zwischen einer Anzahl von Lasern, die aufweist:
eine Anzahl von Frequenzabstand-Stabilisierungseinheiten (100A, 100B), von denen jede aufweist: einen Signalgenerator (102A, 102B) zum Erzeugen eines externen Signals aus einem frequenzgewobbelten Signal, einen Referenzlaser (101A, 101B), an den das frequenzgewobbelte Signal geliefert wird, eine Anzahl von Sendelasern (111A₁-111A₃, 111B₁-111B₃), von denen jeder eine Lichtleistung in einem Frequenzbereich eines zugehörigen Referenzlasers der Anzahl von Referenzlasern emittiert, einen Lichtteiler (104A, 104B) zum Teilen einer Lichtleistung des Referenzlasers in mindestens drei Lichtleistungen (105A, 106A, 107A; 105B, 106B, 107B), einen ersten Optokoppler (114A, 114B) zum Kombinieren von Lichtleistungen aus der Anzahl von Sendelasern, einen zweiten Optokoppler (116A, 116B) zum Kombinieren einer (107A, 107B) der mindestens drei Lichtleistungen und einer in dem ersten Optokoppler kombinierten Lichtleistung, einen Lichtresonator (108A, 108B), durch den eine weitere (106A, 106B) der mindestens drei Lichtleistungen läuft, um zu Resonanzfrequenzspitzen gehörende Referenzlichtleistungen zu erzeugen, erste Einrichtungen (109A, 109B) zum Konvertieren der Referenzlichtleistungen in elektrische Referenzimpulse, zweite Einrichtungen (118A, 118B) zum Konvertieren einer in dem zweiten Optokoppler erhaltenen kombinierten Lichtleistung in ein elektrisches Signal, ein Tiefpaßfilter (110, 405), durch das eine Niederfrequenzkomponente des elektrischen Signals hindurchgeht, um Schwebungsimpulse zu erzeugen, die den Frequenzen der Anzahl von Sendelasern entsprechen, Einrichtungen (110, 410) zum Erzeugen von Fehlersignalen entsprechend einer Differenz von Auftrittszeiten zwischen den Referenzimpulsen und den Schwebungsimpulsen und Einrichtungen (119A₁-119A₃, 119B₁-119B₃) zum Steuern der Anzahl von Sendelasern, die entsprechend den Fehlersignalen derart zu steuern sind, daß die Fehlersignale einen bestimmten Wert annehmen;
einen Optokoppler (125) zum Kombinieren restlicher Lichtleistungen (105A, 105B) der mindestens drei Lichtleistungen der Anzahl von Frequenzabstand-Stabilisierungseinheiten, um eine kombinierte frequenzgewobbelte Lichtleistung zu erzeugen;
einen Lichtresonator (126) mit periodischen Resonanzfrequenzen, durch den die kombinierte frequenzgewobbelte Lichtleistung durchläuft, um eine Referenzlichtleistung bei den periodischen Resonanzfrequenzen zu erzeugen, wobei ein Intervall zwischen den periodischen Resonanzfrequenzen des Lichtresonators gleich einem bestimmten Frequenzabstand zwischen der Anzahl von Referenzlasern ist;
eine Einrichtung (127) zum Konvertieren der Referenzlichtleistung in eine Folge von elektrischen Referenzimpulsen;
mehrere Einrichtungen (128A, 128B) zum Detektieren eines entsprechenden Lichtsignals aus einer Anzahl von ersten frequenzgewobbelten Lichtsignalen, die aus der Folge von elektrischen Referenzimpulsen synchron mit dem externen Signal, welches von einem zugehörigen Signalgenerator der Anzahl von externen Signalgeneratoren geliefert wird, abgeteilt werden, um ein synchronisiertes elektrisches Signal zu erzeugen; und
mehrere Tiefpaßfilter (129A, 129B), von denen jedes ein zugehöriges synchronisiertes elektrisches Signal hindurchläßt, um eine Niederfrequenzkomponente jedes der synchronisierten elektrischen Signale zu erhalten, wobei die Zahl der Tiefpaßfilter die Anzahl der Frequenzabstand-Stabilisierungseinheiten ist.

4. Vorrichtung zur Stabilisierung des Frequenzabstands zwischen einer Anzahl von Lasern, die aufweist:
eine Anzahl von Frequenzabstand-Stabilisierungseinheiten (150A, 150B), von denen jede aufweist: einen Signalgenerator (102A, 102B) zum Erzeugen eines externen Signals, das ein frequenzgewobbeltes Signal ist, einen Referenzlaser (101A, 101B), an den das frequenzgewobbelte Signal in einem Frequenzbereich von dem Signalgenerator geliefert wird, eine Anzahl von Lasern (111A₁-111A₃, 111B₁-111B₃), die Lichtleistungen jeweils bei einer Frequenz in dem Frequenzbereich des Frequenzwobbels der Lichtleistung von dem zugehörigen Referenzlaser der Anzahl von Referenzlasern emittiert, einen Lichtteiler (104A, 104B) zum Teilen der Lichtleistung des Referenzlasers in mindestens drei Lichtleistungen (105A, 106A, 107A; 105B, 106B, 107B), einen ersten Optokoppler (114A, 114B) zum Kombinieren von Lichtleistungen aus der Anzahl von Lasern, einen zweiten Optokoppler (116A, 116B) zum Kombinieren einer (107A, 107B) der mindestens drei Lichtleistungen und der in dem ersten Optokoppler kombinierten Lichtleistungen, Einrichtungen (118A, 118B) zum Konvertieren der in dem zweiten Optokoppler erhaltenen kombinierten Lichtleistung in ein elektrisches Signal, ein Tiefpaßfilter (110, 405), durch das eine Niederfrequenzkomponente des elektrischen Signals hindurchgeht, um Schwebungsimpulse zu erzeugen, die den Frequenzen der Mehrfachlaser entsprechen, Einrichtungen (110, 410) zum Erzeugen von Fehlersignalen entsprechend der Differenz der Auftrittszeiten zwischen Referenzimpulsen und den Schwebungsimpulsen und Einrichtungen (119A₁-119A₃, 119B₁-119B₃) zum Steuern der Mehrfachlaser, die entsprechend den Fehlersignalen derart zu steuern sind, daß die Fehlersignale einen bestimmten Wert annehmen;
einen ersten Optokoppler (125), der alle der ersten frequenzgewobbelten Lichtleistungen (105A, 105B) der Anzahl von Frequenzabstand-Stabilisierungseinheiten kombiniert, um eine kombinierte frequenzgewobbelte Lichtleistung zu erzeugen;
einen ersten Lichtresonator (126) mit periodischen Resonanzfrequenzen, durch den die kombinierte frequenzgewobbelte Lichtleistung durchläuft, um eine erste kombinierte Referenzlichtleistung bei den periodischen Resonanzfrequenzen zu erzeugen, wobei das Intervall zwischen den periodischen Resonanzfrequenzen des ersten Lichtresonators gleich einem bestimmten Frequenzabstand zwischen der Anzahl von Referenzlasern ist;
eine Einrichtung (127) zum Konvertieren der ersten kombinierten Referenzlichtleistung in eine erste Folge von kombinierten elektrischen Referenzimpulsen;
mehrere Einrichtungen (128A, 128B) zum Detektieren eines entsprechenden Lichtsignals aus einer Anzahl von ersten frequenzgewobbelten Lichtsignalen, die aus der ersten Folge von kombinierten elektrischen Referenzimpulsen synchron mit dem externen Signal, welches von dem zugehörigen Signalgenerator der Anzahl von externen Signalgeneratoren geliefert wird, abgetrennt werden, um ein synchronisiertes elektrisches Signal zu erzeugen; und
mehrere Tiefpaßfilter (129A, 129B), von denen jedes ein zugehöriges synchronisiertes elektrisches Signal hindurchläßt, um eine Niederfrequenzkomponente jedes der synchronisierten elektrischen Signale zu erhalten, und deren Anzahl derjenigen der Frequenzabstand-Stabilisierungseinheiten entspricht;
einen zweiten Lichtresonator (132) mit periodischen Resonanzfrequenzen, durch den eine geteilte Lichtleistung (131) der kombinierten frequenzgewobbelten Lichtleistung läuft, um eine zweite kombinierte Referenzlichtleistung bei den periodischen Resonanzfrequenzen zu erzeugen, wobei das Intervall zwischen den periodischen Resonanzfrequenzen des zweiten Lichtresonators gleich einem bestimmten Frequenzabstand zwischen der Anzahl von Lasern ist;
einen Lichtteiler (133), der die zweite kombinierte Referenzlichtleistung in mehrere zweite Referenzlichtleistungen teilt, deren Anzahl der Anzahl von Frequenzabstand-Stabilisierungseinheiten entspricht;
mehrere zweite Optokoppler (134A, 134B), von denen jeder jede der zweiten frequenzgewobbelten Lichtleistungen (106) von jeder der Frequenzabstand-Stabilisierungseinheiten und eine der Anzahl von zweiten Referenzlichtleistungen kombiniert, um eine dritte Referenzlichtleistung zu erzeugen;
mehrere Einrichtungen (135A, 135B; 110A, 110B; 402) zum Konvertieren der dritten Referenzlichtleistung in die Referenzimpulse.

5. Vorrichtung zur Stabilisierung des Frequenzabstands zwischen einer Anzahl von Lasern nach Anspruch 3 oder 4,
wobei der Signalgenerator (102A, 102B) ein Signalgenerator ist, der zwischen einem Sägezahngenerator, einem Dreieckgenerator und einem Sinusgenerator ausgewählt wird.

6. Vorrichtung zur Stabilisierung des Frequenzabstands zwischen einer Anzahl von Lasern nach Anspruch 3 oder 4,
wobei der Sendelaser (111A₁-111A₃, 111B₁-111B₃) ein Halbleiterlaser ist.

7. Vorrichtung zur Stabilisierung des Frequenzabstands zwischen einer Anzahl von Lasern nach Anspruch 3 oder 4,
wobei der Referenzlaser (101A, 101B) ein DBR-LD ist.

8. Vorrichtung zur Stabilisierung des Frequenzabstands zwischen einer Anzahl von Lasern nach Anspruch 3 oder 4,
wobei der Sendelaser (111A₁-111A₃, 111B₁-111B₃) ein DFB-LD ist.

9. Vorrichtung zur Stabilisierung des Frequenzabstands zwischen einer Anzahl von Lasern nach Anspruch 3 oder 4,
wobei der Lichtresonator (108A, 108B, 126; 132) ein Fabry-Perot-Lichtresonator ist.

10. Vorrichtung zur Stabilisierung des Frequenzabstands zwischen einer Anzahl von Lasern nach Anspruch 3 oder 4,
wobei die Detektionseinrichtung (128A, 128B) eine Detektionseinrichtung ist, die zwischen einem Einfangverstärker, einem analog arbeitenden Mischer des Brückentyps und einer digital arbeitenden Exklusiv-ODER (EX-OR) Schaltung ausgewählt wird.

## Revendications

1. Méthode pour la stabilisation de la séparation des fréquences d'oscillation entre une pluralité de dispositifs laser, caractérisée en ce qu'elle comprend :
le balayage des fréquences d'oscillation d'une pluralité de dispositifs laser de référence (101A, 101B) selon un signal correspondant de signaux externes fournis par une pluralité de générateurs de signaux externes (102A, 102B) pour émettre différents signaux lumineux de sortie à fréquence balayée ;
la division (104) de chacun desdits signaux lumineux de sortie à fréquence balayée émis par chacun de ladite pluralité des dispositifs laser de référence en des premier, deuxième et troisième signaux lumineux de sortie à fréquence balayée (105, 106, 107), respectivement ;
la combinaison (125) dudit premier signal lumineux de sortie à fréquence balayée (105) de ladite pluralité des dispositifs laser de référence pour produire un signal lumineux de sortie à fréquence balayée combiné ;
le passage dudit signal lumineux de sortie à fréquence balayée combiné dans un premier résonateur optique (126) ayant des fréquences de résonance périodiques pour produire un premier signal lumineux de sortie de référence auxdites fréquences de résonance périodiques, l'intervalle entre lesdites fréquences de résonance périodiques dudit premier résonateur optique étant égal à une séparation prédéterminée des fréquences d'oscillation entre ladite pluralité des dispositifs laser de référence ;
la conversion (127) dudit premier signal lumineux de sortie de référence en un premier train d'impulsions électriques de référence ;
la division dudit premier train d'impulsions électriques de référence en une pluralité de premiers trains d'impulsions électriques de référence, le nombre de division étant égal au nombre de ladite pluralité des dispositifs laser de référence ;
la détection (128) de chacun de ladite pluralité des premiers trains d'impulsions électriques de référence en synchronisme avec un signal externe correspondant fourni par un générateur de signaux correspondant de ladite pluralité des générateurs de signaux externes pour produire des signaux électriques synchronisés ;
le filtrage (129) de chacun desdits signaux électriques synchronisés pour obtenir une composante à basse fréquence de chacun desdits signaux électriques synchronisés comme signal d'erreur de référence ;
la fourniture de chaque signal d'erreur de référence à un dispositif laser correspondant de ladite pluralité des dispositifs laser de référence pour commander les fréquences d'oscillation de chacun de ladite pluralité des dispositifs laser de référence, de telle manière que la fréquence centrale moyenne de chacun de ladite pluralité des dispositifs laser de référence soit stabilisée à une des crêtes de transmission dudit premier résonateur optique (126) ;
la commande d'une pluralité de groupes de dispositifs laser (111A₁ - 111A₃, 111B₁ - 111B₃), chaque groupe incluant une pluralité de dispositifs laser de transmission pour émettre des signaux lumineux de sortie ayant des fréquences d'oscillation comprises dans une plage de fréquences balayées d'un signal lumineux de sortie d'un dispositif laser de référence correspondant de ladite pluralité des dispositifs laser de référence ;
le passage de chacun desdits deuxièmes signaux lumineux de sortie à fréquence balayée (106) émis par ladite pluralité des dispositifs laser de référence dans un résonateur optique correspondant d'une pluralité de deuxièmes résonateurs optiques (108A, 108B) ayant chacun des fréquences de résonance périodiques pour produire des deuxièmes signaux lumineux de sortie de référence auxdites fréquences de résonance périodiques, l'intervalle entre lesdites fréquences de résonance périodiques de chacun desdits deuxièmes résonateurs optiques étant égal à une séparation prédéterminée des fréquences d'oscillation entre ladite pluralité des dispositifs laser de transmission dans chaque groupe ;
la conversion (109) de chacun desdits deuxièmes signaux lumineux de sortie de référence en un deuxième train d'impulsions électriques de référence ;
la combinaison (116) de chacun desdits troisièmes signaux lumineux de sortie à fréquence balayée (107) et des signaux lumineux de sortie de ladite pluralité des dispositifs laser de transmission dans chaque groupe pour produire des signaux lumineux combinés ;
la conversion (118) desdits signaux lumineux combinés en signaux électriques combinés ;
le filtrage (110, 405) desdits signaux électriques combinés pour produire un train d'impulsions de battement correspondant auxdites fréquences d'oscillation de ladite pluralité des dispositifs laser ;
la comparaison (110, 410) des temps d'apparition de chacune dudit train d'impulsions de battement et de ceux du train correspondant desdits deuxièmes trains d'impulsions électriques de référence pour produire un signal d'erreur correspondant à la différence de temps entre ceux-ci ; et,
la commande (119) des fréquences d'oscillation de ladite pluralité des dispositifs laser de transmission dans chaque groupe, de telle manière que ledit signal d'erreur soit approximativement égal à une valeur prédéterminée dans un groupe respectif de ladite pluralité des dispositifs laser.

2. Méthode pour la stabilisation de la séparation des fréquences d'oscillation entre une pluralité de dispositifs laser, caractérisée en ce qu'elle comprend :
le balayage des fréquences d'oscillation d'une pluralité de dispositifs laser de référence (101A, 101B) selon un signal correspondant de signaux externes fournis par une pluralité de générateurs de signaux externes (102A, 102B) pour émettre différents signaux lumineux de sortie à fréquence balayée ;
la division (104) de chacun desdits signaux lumineux de sortie à fréquence balayée émis par chacun de ladite pluralité des dispositifs laser de référence en des premier, deuxième et troisième signaux lumineux de sortie à fréquence balayée (105, 106, 107), respectivement ;
la combinaison (125) desdits premiers signaux lumineux de sortie à fréquence balayée (105) de ladite pluralité des dispositifs laser de référence pour produire un signal lumineux de sortie à fréquence balayée combiné ;
la division (125) dudit signal lumineux de sortie à fréquence balayée combiné en des premier et deuxième signaux lumineux de sortie à fréquence balayée combinés ;
le passage dudit premier signal lumineux de sortie à fréquence balayée combiné dans un premier résonateur optique (126) ayant des fréquences de résonance périodiques pour produire un premier signal lumineux de référence combiné auxdites fréquences de résonance périodiques, l'intervalle entre lesdites fréquences de résonance périodiques dudit premier résonateur optique étant égal à une séparation prédéterminée des fréquences d'oscillation entre ladite pluralité des dispositifs laser de référence ;
la conversion (127) dudit premier signal lumineux de sortie de référence combiné en un premier train d'impulsions électriques de référence combinées ;
la division dudit premier train d'impulsions électriques de référence combinées en une pluralité de premiers trains d'impulsions électriques de référence, le nombre de division étant égal au nombre de ladite pluralité des dispositifs laser de référence ;
la détection (128) de chacun de ladite pluralité des premiers trains d'impulsions électriques de référence en synchronisme avec un signal externe correspondant fourni par un générateur de signaux correspondant de ladite pluralité des générateurs de signaux externes pour produire un signal électrique synchronisé ;
le filtrage (129) de chacun desdits signaux électriques synchronisés pour obtenir une composante à basse fréquence de chacun desdits signaux électriques synchronisés comme signal d'erreur de référence ;
la fourniture de chaque signal d'erreur de référence à un dispositif laser correspondant de ladite pluralité des dispositifs laser de référence pour commander les fréquences d'oscillation de chacun de ladite pluralité des dispositifs laser de référence, de telle manière que la fréquence centrale moyenne de chacun de ladite pluralité des dispositifs laser de référence soit stabilisée à une des crêtes de transmission dudit premier résonateur optique ;
le passage dudit deuxième signal lumineux de sortie à fréquence balayée combiné (131) dans un deuxième résonateur optique (132) ayant des fréquences de résonance périodiques pour produire un deuxième signal lumineux de sortie de référence auxdites fréquences de résonance périodiques, l'intervalle entre lesdites fréquences de résonance périodiques dudit deuxième résonateur optique étant égal à une séparation prédéterminée des fréquences d'oscillation entre ladite pluralité des dispositifs laser de transmission dans chaque groupe ;
la division (133) dudit deuxième signal lumineux de sortie de référence en une pluralité de deuxièmes signaux lumineux de sortie de référence, le nombre de division étant égal au nombre de ladite pluralité des dispositifs laser de référence ;
la combinaison (134) de chacun desdits deuxièmes signaux lumineux de sortie à fréquence balayée (106) et de chacun desdits deuxièmes signaux lumineux de sortie de référence pour produire un troisième signal lumineux de sortie de référence ;
la conversion (135, 110, 402) de chacun desdits troisièmes signaux lumineux de sortie de référence en un deuxième train d'impulsions électriques de référence ;
la commande d'une pluralité de groupes de dispositifs laser de transmission, chaque groupe incluant une pluralité de dispositifs laser de transmission pour émettre des signaux lumineux de sortie ayant des fréquences d'oscillation dans une plage de fréquences balayées d'un signal lumineux de sortie d'un dispositif laser de référence correspondant de ladite pluralité des dispositifs laser de référence ;
la combinaison (116) de chacun desdits troisièmes signaux lumineux de sortie à fréquence balayée (107) et des signaux lumineux de sortie de ladite pluralité des dispositifs laser de transmission dans chaque groupe pour produire des signaux lumineux combinés ;
la conversion (118) de chacun desdits signaux lumineux combinés en un signal électrique combiné ;
le filtrage (110, 405) de chacun desdits signaux électriques combinés pour produire un train d'impulsions de battement correspondant auxdites fréquences d'oscillation d'un groupe correspondant de ladite pluralité des dispositifs laser de transmission ;
la comparaison (110, 410) des temps d'apparition de chacune dudit train d'impulsions de battement et de ceux d'un train correspondant desdits deuxièmes trains d'impulsions électriques de référence pour produire un signal d'erreur correspondant à une différence de temps entre ceux-ci ; et,
la commande (119) des fréquences d'oscillation de ladite pluralité des dispositifs laser de transmission dans chaque groupe, de telle manière que ledit signal d'erreur soit approximativement égal à une valeur prédéterminée dans un groupe respectif de ladite pluralité des dispositifs laser.

3. Dispositif pour la stabilisation de la séparation des fréquences d'oscillation entre une pluralité de dispositifs laser, comprenant :
une pluralité d'unités de stabilisation de la séparation des fréquences d'oscillation (100A, 100B), comprenant chacune un générateur de signaux (102A, 102B) pour engendrer un signal externe d'un signal à fréquence d'oscillation balayée, un dispositif laser de référence (101A, 101B) auquel est fourni ledit signal à fréquence d'oscillation balayée, une pluralité de dispositifs laser de transmission (111A₁-111A₃, 111B₁-111B₃) émettant chacun un signal lumineux de sortie dans une plage de fréquences d'oscillation d'un dispositif laser de référence correspondant de ladite pluralité des dispositifs laser de référence, un diviseur optique (104A, 104B) pour diviser un signal lumineux de sortie dudit dispositif laser de référence en au moins trois signaux lumineux de sortie (105A, 106A, 107A ; 105B, 106B, 107E), un premier coupleur optique (114A, 114B) pour combiner les signaux lumineux de sortie de ladite pluralité des dispositifs laser de transmission, un deuxième coupleur optique (116A, 116B) pour combiner un (107A, 107B) desdits au moins trois signaux lumineux de sortie et un signal lumineux de sortie combiné dans ledit premier coupleur optique, un résonateur optique (108A, 108B) dans lequel on fait passer un autre (106A, 106B) desdits au moins trois signaux lumineux de sortie pour produire des signaux lumineux de sortie de référence correspondant à des crêtes de fréquences de résonance, un premier moyen (109A, 109B) pour convertir lesdits signaux lumineux de sortie de référence en impulsions électriques de référence, un deuxième moyen (118A, 118B) pour convertir un signal lumineux de sortie combiné obtenu dans ledit deuxième coupleur optique en un signal électrique, un filtre passe-bas (110, 405) dans lequel on fait passer une composante à basse fréquence dudit signal électrique pour produire des impulsions de battement correspondant auxdites fréquences d'oscillation de ladite pluralité des dispositifs laser de transmission, un moyen (110, 410) pour produire des signaux d'erreur selon la différence des temps d'apparition entre lesdites impulsions de référence et lesdites impulsions de battement, et un moyen (119A₁-119A₃, 119B₁-119B₃) pour commander l'excitation de ladite pluralité des dispositifs laser de transmission selon lesdits signaux d'erreur, de telle manière que lesdits signaux d'erreur prennent une valeur prédéterminée ;
un coupleur optique (125) pour combiner les autres signaux lumineux de sortie (105A, 105B) desdits au moins trois signaux lumineux de sortie de ladite pluralité des unités de stabilisation de la séparation des fréquences d'oscillation pour produire un signal lumineux de sortie à fréquence balayée combiné ;
un résonateur optique (126) ayant des fréquences de résonance périodiques dans lequel on fait passer ledit signal lumineux de sortie à fréquence balayée combiné pour produire un signal lumineux de sortie de référence auxdites fréquences de résonance périodiques, l'intervalle entre lesdites fréquences de résonance périodiques dudit résonateur optique étant égal à une séparation prédéterminée des fréquences d'oscillation entre ladite pluralité des dispositifs laser de référence ;
un moyen (127) pour convertir ledit signal lumineux de sortie de référence en un train d'impulsions électriques de référence ;
une pluralité de moyens (128A, 128B) pour détecter un signal lumineux correspondant d'une pluralité de premiers signaux lumineux à fréquence balayée qui sont divisés à partir dudit train d'impulsions électriques de référence en synchronisme avec ledit signal externe fourni par un générateur de signaux correspondant de ladite pluralité des générateurs de signaux externes pour produire un signal électrique synchronisé ; et,
une pluralité de filtres passe-bas (129A, 129B) laissant passer chacun un signal électrique synchronisé correspondant pour obtenir une composante à basse fréquence de chacun desdits signaux électriques synchronisés, le nombre desdits filtres passe-bas étant égal au nombre desdites unités de stabilisation de la séparation des fréquences d'oscillation.

4. Dispositif pour la stabilisation de la séparation des fréquences d'oscillation entre une pluralité de dispositifs laser, comprenant :
une pluralité d'unités de stabilisation de la séparation des fréquences d'oscillation (150A, 150E), dont chacune comprend un générateur de signaux (102A, 102B) pour engendrer un signal externe qui est un signal à fréquence d'oscillation balayée, un dispositif laser de référence (101A, 101B) auquel est fourni ledit signal à fréquence d'oscillation balayée dans une plage de fréquences par ledit générateur de signaux, une pluralité de dispositifs laser (111A₁-111A₃, 111B₁-111B₃) émettant des signaux lumineux de sortie chacun à une fréquence d'oscillation dans la plage de fréquences dudit balayage des fréquences d'oscillation du signal lumineux de sortie du dispositif laser de référence correspondant de ladite pluralité des dispositifs laser de référence, un diviseur optique (104A, 104B) pour diviser le signal lumineux de sortie dudit dispositif laser de référence en au moins trois signaux lumineux de sortie (105A, 106A, 107A ; 105B, 106B, 107B), un premier coupleur optique (114A, 114B) pour combiner les signaux lumineux de sortie de ladite pluralité des dispositifs laser, un deuxième coupleur optique (116A, 116B) pour combiner un (107A, 107B) desdits au moins trois signaux lumineux de sortie et les signaux lumineux de sortie combinés dans ledit premier coupleur optique, un moyen (118A, 118B) pour convertir le signal lumineux de sortie combiné obtenu dans ledit deuxième coupleur optique en un signal électrique, un filtre passe-bas (110, 405) dans lequel on fait passer une composante à basse fréquence dudit signal électrique pour produire des impulsions de battement correspondant auxdites fréquences d'oscillation de ladite pluralité des dispositifs laser, un moyen (110, 410) pour produire des signaux d'erreur selon la différence des temps d'apparition entre les impulsions de référence et lesdites impulsions de battement, et un moyen (119A₁-119A₃, 119B₁-119B₃) pour commander l'excitation de ladite pluralité des dispositifs laser selon lesdits signaux d'erreur, de telle manière que lesdits signaux d'erreur prennent une valeur prédéterminée ;
un premier coupleuroptique (125) qui combine tous les premiers signaux lumineux de sortie à fréquence balayée (105A, 105B) de ladite pluralité des unités de stabilisation de la séparation des fréquences d'oscillation pour produire un signal lumineux de sortie à fréquence balayée combiné ;
un premier résonateur optique (126) ayant des fréquences de résonance périodiques dans lequel on fait passer ledit signal lumineux de sortie à fréquence balayée combiné pour produire un premier signal lumineux de sortie de référence combiné auxdites fréquences de résonance périodiques, l'intervalle entre lesdites fréquences de résonance périodiques dudit premier résonateur optique étant égal à une séparation prédéterminée des fréquences d'oscillation entre ladite pluralité des dispositifs laser de référence ;
un moyen (127) pour convertir ledit premier signal lumineux de sortie de référence combiné en un premier train d'impulsions électriques de référence combinées ;
une pluralité de moyens (128A, 128B) pour détecter un signal lumineux correspondant d'une pluralité de premiers signaux lumineux à fréquence balayée qui sont divisés à partir dudit premier train d'impulsions électriques de référence combinées en synchronisme avec ledit signal externe fourni par le générateur de signaux correspondant de ladite pluralité des générateurs de signaux externes pour produire un signal électrique synchronisé ; et,
une pluralité de filtres passe-bas (129A, 129B) dans chacun desquels on fait passer un signal électrique synchronisé correspondant pour obtenir une composante à basse fréquence de chacun desdits signaux électriques synchronisés, dont le nombre correspond à celui desdites unités de stabilisation de la séparation des fréquences d'oscillation ;
un deuxième résonateur optique (132) ayant des fréquences de résonance périodiques dans lequel on fait passer un signal lumineux de sortie divisé (131) dudit signal lumineux de sortie à fréquence balayée combiné pour produire un deuxième signal lumineux de sortie de référence combiné auxdites fréquences de résonance périodiques, l'intervalle entre lesdites fréquences de résonance périodiques dudit deuxième résonateur optique étant égal à une séparation prédéterminée des fréquences d'oscillation entre ladite pluralité des dispositifs laser ;
un diviseur optique (133) qui divise ledit deuxième signal lumineux de sortie de référence combiné en une pluralité de deuxièmes signaux lumineux de sortie de référence dont le nombre correspond à celui de ladite pluralité des unités de stabilisation de la séparation des fréquences d'oscillation ;
une pluralité de deuxièmes coupleurs optiques (134A, 134B) dont chacun combine chacun desdits deuxièmes signaux lumineux de sortie à fréquence balayée (106) de chacune desdites unités de stabilisation de la séparation des fréquences d'oscillation et l'un de ladite pluralité des deuxièmes signaux lumineux de sortie de référence pour produire un troisième signal lumineux de sortie de référence ;
une pluralité de moyens (135A, 135B ; 110A, 110B ; 402) pour convertir ledit troisième signal lumineux de sortie de référence en lesdites impulsions de référence.

5. Dispositif pour la stabilisation de la séparation des fréquences d'oscillation entre une pluralité de dispositifs laser selon l'une quelconque des revendications 3 et 4, dans lequel ledit générateur de signaux (102A, 102B) est un générateur de signaux choisi parmi un générateur d'ondes en dents de scie, un générateur d'ondes triangulaires, et un générateur d'ondes sinusoïdales.

6. Dispositif pour la stabilisation de la séparation des fréquences d'oscillation entre une pluralité de dispositifs laser selon l'une quelconque des revendications 3 et 4, dans lequel ledit dispositif laser de transmission (111A₁-111A₃, 111B₁-111B₃) est un dispositif laser à semiconducteur.

7. Dispositif pour la stabilisation de la séparation des fréquences d'oscillation entre une pluralité de dispositifs laser selon l'une quelconque des revendications 3 et 4, dans lequel ledit dispositif laser de référence (101A, 101B) est un dispositif laser de type à réflecteurs de Bragg répartis DBR-LD.

8. Dispositif pour la stabilisation de la séparation des fréquences d'oscillation entre une pluralité de dispositifs laser selon l'une quelconque des revendications 3 et 4, dans lequel ledit dispositif laser de transmission (111A₁-111A₃, 111B₁-111B₃) est un dispositif laser de type à contre-réaction répartie DFB-LD.

9. Dispositif pour la stabilisation de la séparation des fréquences d'oscillation entre une pluralité de dispositifs laser selon l'une quelconque des revendications 3 et 4, dans lequel ledit résonateur optique (108A, 108B, 126 ; 132) est un résonateur optique Fabry-Perot.

10. Dispositif pour la stabilisation de la séparation des fréquences d'oscillation entre une pluralité de dispositifs laser selon l'une quelconque des revendications 3 et 4, dans lequel ledit moyen de détection (128A, 128B) est un moyen de détection choisi parmi un amplificateur de verrouillage, un mélangeur de type à équilibrage fonctionnant en analogique, et un circuit OU-exclusif (OU-EX) fonctionnant en numérique.
